# EUROPEAN PATENT APPLICATION

(11) **EP 4 210 459 A1**
(43) Date of publication of application: **12.07.2023**
(21) Application number: 23150910.0
(22) Date of filing: 10.01.2023
(51) Int. Cl.: H10K 85/60, H10K 50/18, H10K 50/19

(54) **LIGHT-EMITTING DEVICE AND ELECTRONIC APPARATUS INCLUDING THE LIGHT-EMITTING DEVICE**

(30) Priority: 11.01.2022 KR 20220004303
(71) Applicant: Samsung Display Co., Ltd., Yongin-si, Gyeonggi-do 17113 (KR)
(72) Inventor: LEE, Jongwon, 17113 Yongin-si (KR); KIM, Seungcheol, 17113 Yongin-si (KR); LEE, Changmin, 17113 Yongin-si (KR); LEE, Hyunshik, 17113 Yongin-si (KR)
(74) Representative: Russell, Tim

(57) **Abstract**

A light-emitting device includes: a first electrode (110); a second electrode (150) facing the first electrode; an interlayer (130)arranged between the first electrode and the second electrode and including an emission layer; and a hole transport region arranged between the first electrode and the emission layer, wherein the hole transport region includes an electron blocking layer, and the electron blocking layer includes a heterocyclic compound represented by Formula 1.

## Description

### CROSS-REFERENCE TO RELATED APPLICATION

This application claims priority to and the benefit of Korean Patent Application No. 10-2022-0004303, filed on January 11, 2022, in the Korean Intellectual Property Office, the entire content of which is incorporated herein by reference.

### BACKGROUND

### 1. Field

One or more aspects of embodiments of the present disclosure relate to a light-emitting device and an electronic apparatus including the light-emitting device.

### 2. Description of the Related Art

Light-emitting devices are devices that convert electrical energy into light energy. Examples of such light-emitting devices may include organic light-emitting devices in which a light-emitting material is an organic material, and quantum dot light-emitting devices in which the light-emitting material is a quantum dot.

In a light-emitting device, a first electrode is arranged on a substrate, and a hole transport region, an emission layer, an electron transport region, and a second electrode are sequentially arranged on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transition from an excited state to a ground state to thereby generate light.

### SUMMARY

The invention is defined by the claims.

One or more aspects of embodiments of the present disclosure are directed toward a light-emitting device and an electronic apparatus including the light-emitting device.

Additional aspects will be set forth in part in the description which follows and, in part, will be apparent from the description, or may be learned by practice of the presented embodiments of the disclosure.

The present disclosure provides a light-emitting device comprising a first electrode,
a second electrode facing the first electrode,
an interlayer between the first electrode and the second electrode and comprising an emission layer, and a hole transport region between the first electrode and the interlayer,
wherein the hole transport region comprises an electron blocking layer, and
the electron blocking layer comprises a heterocyclic compound represented by Formula 1:

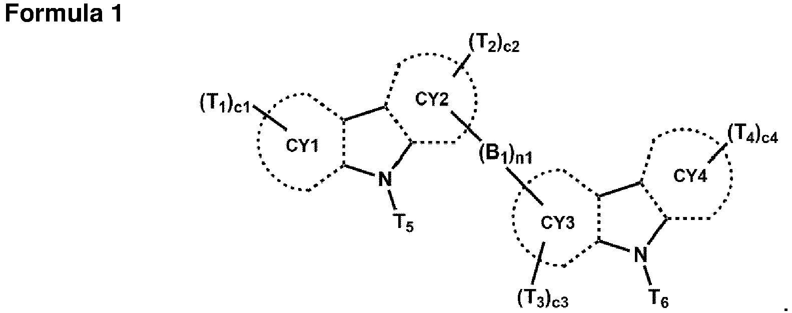

In Formula 1,
ring CY1 to ring CY4 are each independently a C₃-C₆₀ carbocyclic group or a C₁-C₆₀ heterocyclic group,
T₁ is *-(L₁)ₐ₁-(R₁)_{b1},
T₂ is *-(L₂)ₐ₂-(R₂)_{b2},
T₃ is *-(L₃)ₐ₃-(R₃)_{b3},
T₄ is *-(L₄)ₐ₄-(R₄)_{b4},
T₅ is *-(L₅)ₐ₅-(R₅)_{b5},
T₆ is *-(L₆)ₐ₆-(R₆)_{b6},
* indicates a binding site to a neighboring atom,
c1 to c4 are each independently an integer from 0 to 10,
B₁ and L₁ to L₆ are each independently a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
n1 and a1 to a6 are each independently an integer from 0 to 3,
R₁ to R₆ are each independently hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, a C₇-C₆₀ aryl alkyl group that is unsubstituted or substituted with at least one R₁₀ₐ, a C₂-C₆₀ heteroaryl alkyl group that is unsubstituted or substituted with at least one R₁₀ₐ, -Si(Q₁)(Q₂)(Q₃), -N(Q₁)(Q₂), -B(Q₁)(Q₂), - C(=O)(Q₁), -S(=O)₂(Q₁), or -P(=O)(Q₁)(Q₂),
b1 to b6 are each independently an integer from 0 to 10,
R₁₀ₐ is:
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof,
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof, or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ are each independently hydrogen; deuterium, -F, -Cl, -Br, -I, a hydroxyl group, a cyano group, a nitro group, or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₇-C₆₀ aryl alkyl group, or a C₂-C₆₀ heteroaryl alkyl group, each unsubstituted or substituted with deuterium, -F, a cyano group, a C₁-C₆₀ alkyl group, a C₁-C₆₀ alkoxy group, a phenyl group, a biphenyl group, a C₁-C₆₀ heterocyclic group, or any combination thereof.

According to one or more embodiments, provided is an electronic apparatus comprising the light-emitting device.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic view of a structure of a light-emitting device according to one or more embodiments;
FIG. 2 is a schematic view of a structure of an electronic apparatus according to one or more embodiments; and
FIG. 3 is a schematic view of a structure of an electronic apparatus according to one or more other embodiments.

### DETAILED DESCRIPTION

Reference will now be made in more detail to embodiments, examples of which are illustrated in the accompanying drawings, wherein like reference numerals refer to like elements throughout, and duplicative descriptions thereof may not be provided the specification. In this regard, the present embodiments may have different forms and should not be construed as being limited to the descriptions set forth herein. Accordingly, the embodiments are merely described below, by referring to the drawings, to explain aspects of the present description.

As utilized herein, the term "and/or" includes any and all combinations of one or more of the same associated listed items.

As used herein, expressions such as "at least one of", "one of", and "selected from", when preceding a list of elements, modify the entire list of elements and do not modify the individual elements of the list. Throughout the disclosure, the expressions "at least one selected from a, b and c," "at least one of a, b or c," and "at least one of a, b and/or c" may indicate only a, only b, only c, both (e.g., simultaneously) a and b, both (e.g., simultaneously) a and c, both (e.g., simultaneously) b and c, all of a, b, and c, or variations thereof.

Further, the use of "may" when describing embodiments of the present disclosure refers to "one or more embodiments of the present disclosure".

The disclosure may include one or more suitable modifications and one or more suitable embodiments, and specific embodiments will be illustrated in the drawings and described in more detail in the detailed description. Effects and features of the disclosure, and implementation methods therefor will become clear with reference to the embodiments described later together with the drawings. The present disclosure may, however, be embodied in many different forms and should not be construed as limited to the embodiments set forth herein.

It will be understood that, although the terms first, second, etc. may be utilized herein to describe one or more suitable elements, these elements should not be limited by these terms. These terms are only utilized to distinguish one element from another.

In the embodiments described in the present specification, an expression utilized in the singular encompasses the expression of the plural, unless it has a clearly different meaning in the context.

In the present specification, it is to be understood that the terms such as "including," "having," and "comprising" are intended to indicate the existence of the features or components disclosed in the specification, and are not intended to preclude the possibility that one or more other features or components may exist or may be added. For example, unless otherwise limited, terms such as "including" or "having" may refer to either consisting of features or components described in the specification only or further including other components.

The term "Group II" utilized herein may include a Group IIA element and a Group IIB element on the IUPAC periodic table, and examples of the Group II element may include Cd, Mg, and Zn, but embodiments are not limited thereto.

The term "Group III" utilized herein may include a Group IIIA element and a Group IIIB element on the IUPAC periodic table, and examples of the Group III element may include Al, In, Ga, and TI, but embodiments are not limited thereto.

The term "Group IV" utilized herein may include a Group IVA element and a Group IVB element on the IUPAC periodic table, and examples of the Group IV element may include Si, Ge, and Sn, but embodiments are not limited thereto.

The term "Group V" utilized herein may include a Group VA element and a Group VB element on the IUPAC periodic table, and examples of the Group V element may include N, P, As, Sb, and Bi, but embodiments are not limited thereto.

The term "Group VI" utilized herein may include a Group VIA element and a Group VIB element in the IUPAC periodic table, and examples of the Group VI element may include O, S, Se, and Te, but embodiments are not limited thereto.

The term "metal" utilized herein may include metalloid such as Si. Further examples of the metalloid may include B, Ge, As, Sb, Te, and/or the like.

As used herein, the terms "substantially", "about", and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10% or 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

A light-emitting device according to one or more embodiments includes:
a first electrode;
a second electrode facing the first electrode;
an interlayer arranged between the first electrode and the second electrode and including an emission layer; and a hole transport region arranged between the first electrode and the emission layer,
wherein the hole transport region includes an electron blocking layer, and
the electron blocking layer includes a heterocyclic compound represented by Formula 1: 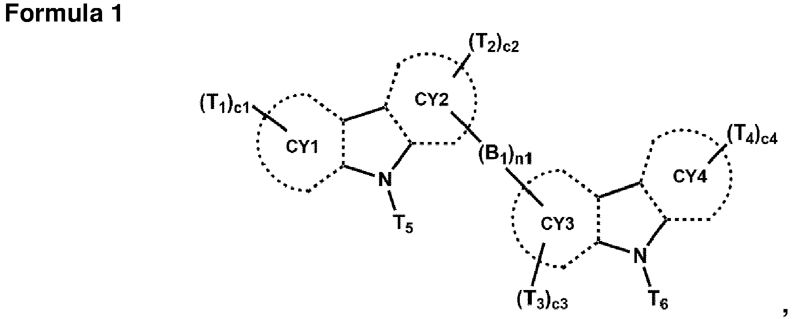
wherein, in Formula 1,
ring CY1 to ring CY4 are each independently a C₃-C₆₀ carbocyclic group or a C₁-C₆₀ heterocyclic group.

In one or more embodiments, in Formula 1, ring CY1 to ring CY4 may each independently be a benzene group, a naphthalene group, a phenanthrene group, a benzoquinoline group, a benzoisoquinoline group, a phenanthridine group, a benzimidazole group, a benzoxazole group, a carbazole group, or a dibenzofuran group.

In one or more embodiments, in Formula 1, ring CY1 to ring CY4 may be identical to each other.

In one or more embodiments, in Formula 1, ring CY2 and ring CY3 may each be a benzene group.

In one or more embodiments, in Formula 1, ring CY1 to ring CY4 may each be a benzene group.

In Formula 1, T₁ is *-(L₁)ₐ₁-(R₁)_{b1}, T₂ is *-(L₂)ₐ₂-(R₂)_{b2}, T₃ is *-(L₃)ₐ₃-(R₃)_{b3}, T₄ is *-(L₄)ₐ₄-(R₄)_{b4}, T₅ is *-(L₅)ₐ₅-(R₅)_{b5}, T₆ is *-(L₆)ₐ₆-(R₆)_{b6}, and * indicates a binding site to a neighboring atom.

In Formula 1, c1 to c4 are each independently an integer from 0 to 10.

c1 to c4 may respectively indicate the numbers of T₁ to T₄. In one or more embodiments, when c1 is an integer of 2 or more, two or more of T₁(s) may be identical to or different from each other. In one or more embodiments, when c2 is an integer of 2 or more, two or more of T₂(s) may be identical to or different from each other. In one or more embodiments, when c3 is an integer of 2 or more, two or more of T₃(s) may be identical to or different from each other. In one or more embodiments, when c4 is an integer of 2 or more, two or more of T₄(s) may be identical to or different from each other.

In one or more embodiments, in Formula 1, c1 and c4 may each independently be an integer from 0 to 4, and c2 and c3 may each independently be an integer from 0 to 3.

In Formula 1, B₁ and L₁ to L₆ are each independently a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

In Formula 1, n1 and a1 to a6 are each independently an integer from 0 to 3.

In one or more embodiments, n1 and a1 to a6 may respectively indicate the numbers of B₁ and L₁ to L₆. In one or more embodiments, when n1 is an integer of 2 or more, two or more of B₁(s) may be identical to or different from each other. In one or more embodiments, when a1 is an integer of 2 or more, two or more of L₁(s) may be identical to or different from each other. In one or more embodiments, when a2 is an integer of 2 or more, two or more of L₂(s) may be identical to or different from each other. In one or more embodiments, when a3 is an integer of 2 or more, two or more of L₃(s) may be identical to or different from each other. In one or more embodiments, when a4 is an integer of 2 or more, two or more of L₄(s) may be identical to or different from each other. In one or more embodiments, when a5 is an integer of 2 or more, two or more of L₅(s) may be identical to or different from each other. In one or more embodiments, when a6 is an integer of 2 or more, two or more of Le(s) may be identical to or different from each other.

In one or more embodiments, when n1 is 0, B₁ may be a single bond. When B₁ is a single bond, two elements which are linked to B₁ via a covalent bond may be directly linked to each other via a single bond. In one or more embodiments, when a1 is 0, L₁ may be a single bond. When L₁ is a single bond, two elements which are linked to L₁ via a covalent bond may be directly linked to each other via a single bond. In one or more embodiments, when a2 is 0, L₂ may be a single bond. When L₂ is a single bond, two elements which are linked to L₂ via a covalent bond may be directly linked to each other via a single bond. In one or more embodiments, when a3 is 0, L₃ may be a single bond. When L₃ is a single bond, two elements which are linked to L₃ via a covalent bond may be directly linked to each other via a single bond. In one or more embodiments, when a4 is 0, L₄ may be a single bond. When L₄ is a single bond, two elements which are linked to L₄ via a covalent bond may be directly linked to each other via a single bond. In one or more embodiments, when a5 is 0, L₅ may be a single bond. When L₅ is a single bond, two elements which are linked to L₅ via a covalent bond may be directly linked to each other via a single bond. In one or more embodiments, when a6 is 0, L₆ may be a single bond. When L₆ is a single bond, two elements which are linked to L₆ via a covalent bond may be directly linked to each other via a single bond.

In one or more embodiments, in Formula 1, B₁ may be: a single bond; or a benzene group that is unsubstituted or substituted with at least one R₁₀ₐ, a naphthalene group that is unsubstituted or substituted with at least one R₁₀ₐ, an anthracene group that is unsubstituted or substituted with at least one R₁₀ₐ, a phenanthrene group that is unsubstituted or substituted with at least one R₁₀ₐ, a benzoquinoline group that is unsubstituted or substituted with at least one R₁₀ₐ, a benzoisoquinoline group that is unsubstituted or substituted with at least one R₁₀ₐ, a phenanthridine group that is unsubstituted or substituted with at least one R₁₀ₐ, a benzimidazole group that is unsubstituted or substituted with at least one R₁₀ₐ, a benzoxazole group that is unsubstituted or substituted with at least one R₁₀ₐ, a carbazole group that is unsubstituted or substituted with at least one R₁₀ₐ, a dibenzofuran group that is unsubstituted or substituted with at least one R₁₀ₐ, a fluorene group that is unsubstituted or substituted with at least one R₁₀ₐ, a dibenzothiophene group that is unsubstituted or substituted with at least one R₁₀ₐ, or a dibenzosilole group that is unsubstituted or substituted with at least one R₁₀ₐ.

In one or more embodiments, in Formula 1, B₁ may be: a single bond; or a benzene group that is unsubstituted or substituted with at least one R₁₀ₐ, a naphthalene group that is unsubstituted or substituted with at least one R₁₀ₐ, a phenanthrene group that is unsubstituted or substituted with at least one R₁₀ₐ, a benzoquinoline group that is unsubstituted or substituted with at least one R₁₀ₐ, a benzoisoquinoline group that is unsubstituted or substituted with at least one R₁₀ₐ, a phenanthridine group that is unsubstituted or substituted with at least one R₁₀ₐ, a benzimidazole group that is unsubstituted or substituted with at least one R₁₀ₐ, a benzoxazole group that is unsubstituted or substituted with at least one R₁₀ₐ, a carbazole group that is unsubstituted or substituted with at least one R₁₀ₐ, or a dibenzofuran group that is unsubstituted or substituted with at least one R₁₀ₐ.

In one or more embodiments, in Formula 1, B₁ may be a single bond.

In one or more embodiments, in Formula 1, n1 may be 0 or 1.

In one or more embodiments, in Formula 1, a case where n1 is 0 and a case where n1 is 1 and B₁ is a single bond may be the same.

In one or more embodiments, in Formula 1,
L₁ to L₆ may each independently be: a single bond; or
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a quinolinylene group, an isoquinolinylene group, a benzoquinolinylene group, a benzoisoquinolinylene group, a dibenzoquinolinylene group, a dibenzoisoquinolinylene group, a biphenylene group, a phenylpyridinylene group, a phenanthrolenylene group, a phenanthridinylene group, a benzimidazolylene group, a benzoxazolylene group, a bipyridinylene group, or a pyridinylene group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a quinolinyl group, an isoquinolinyl group, a benzoquinolinyl group, a dibenzoquinolinyl group, a dibenzoisoquinolinyl group, a biphenyl group, a phenylpyridinyl group, a phenanthrolinyl group, a phenanthridinyl group, a benzoimidazolyl group, a benzoxazolyl group, a dibenzoquinolyl group, a bipyridinyl group, a pyridinyl group, -Si(Q₃₁)(Q₃₂)(Q₃₃), - N(Q₃₁)(Q₃₂), -B(Q₃₁)(Q₃₂), -C(=O)(Q₃₁), -S(=O)₂(Q₃₁), -P(=O)(Q₃₁)(Q₃₂), or a combination thereof.

In one or more embodiments, in Formula 1,
L₁ to L₆ may each independently be: a single bond; or
a phenylene group, a naphthylene group, a spiro-anthracenefluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a thiophenylene group, a furanylene group, a carbazolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a quinolinylene group, an isoquinolinylene group, a benzoquinolinylene group, a benzoisoquinolinylene group, a dibenzoquinolinylene group, a dibenzoisoquinolinylene group, a biphenylene group, a phenylpyridinylene group, a phenanthrolinylene group, a phenanthridinylene group, a benzimidazolylene group, a benzoxazolylene group, a bi pyridinylene group, or a pyridinylene group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a spiro-anthracenefluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a thiophenyl group, a furanyl group, a carbazolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a quinolinyl group, an isoquinolinyl group, a benzoquinolinyl group, a benzoisoquinolinyl group, a dibenzoquinolinyl group, a dibenzoisoquinolinyl group, a biphenyl group, a phenylpyridinyl group, a phenanthrolinyl group, a phenanthridinyl group, a benzoimidazolyl group, a benzoxazolyl group, a bipyridinyl group, a pyridinyl group, or a combination thereof.

In one or more embodiments, in Formula 1,
L₁ to L₆ may each independently be: a single bond; or
a phenylene group, a naphthylene group, a phenanthrenylene group, a carbazolylene group, a dibenzofuranylene group, a dibenzothiophenylene group, a dibenzosilolylene group, a benzoquinolinylene group, a benzoisoquinolinylene group, a phenanthridinylene group, a benzimidazolylene group, or a benzoxazolylene group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a phenanthrenyl group, a carbazolyl group, a dibenzofuranyl group, a dibenzothiophenyl group, a dibenzosilolyl group, a benzoquinolinyl group, a benzoisoquinolinyl group, a phenanthridinyl group, a benzoimidazolyl group, a benzoxazolyl group, or any combination thereof.

In one or more embodiments, in Formula 1, L₁ to L₄ may each be a single bond.

In one or more embodiments, in Formula 1, L₅ and L₆ may each independently be: a single bond; or a phenylene group, a naphthylene group, a phenanthrenylene group, a carbazolylene group, a dibenzofuranylene group, a benzoquinolinylene group, a benzoisoquinolinylene group, a phenanthridinylene group, a benzimidazolylene group, or a benzoxazolylene group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a phenanthrenyl group, a carbazolyl group, a dibenzofuranyl group, a benzoquinolinyl group, a benzoisoquinolinyl group, a phenanthridinyl group, a benzoimidazolyl group, a benzoxazolyl group, or a combination thereof.

In one or more embodiments, in Formula 1, a1 to a6 may each independently be 0 or 1.

In one or more embodiments, in Formula 1, R₁ to R₆ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a C₁-C₂₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indenyl group, an isoindolyl group, an indolyl group, an indazolyl group, a purinyl group, a quinolinyl group, an isoquinolinyl group, a benzoquinolinyl group, a benzoisoquinolinyl group, a quinoxalinyl group, a quinazolinyl group, a cinnolinyl group, a carbazolyl group, a phenanthrolinyl group, a phenanthridinyl group, a benzoimidazolyl group, a benzofuranyl group, a benzothiophenyl group, a benzosilolyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzofluorenyl group, a benzocarbazolyl group, a naphthobenzofuranyl group, a naphthobenzothiophenyl group, naphthobenzosilolyl group, a dibenzofluorenyl group, a dibenzocarbazolyl group, a dinaphthofuranyl group, a dinaphthothiophenyl group, a dinaphthosilolyl group, an indenocarbazolyl group, an indolocarbazolyl group, a benzofuranocarbazolyl group, a benzothienocarbazolyl group, a benzosilolocarbazolyl group, an imidazopyridinyl group, or an imidazopyrimidinyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a C₁-C₂₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indenyl group, an isoindolyl group, an indolyl group, an indazolyl group, a purinyl group, a quinolinyl group, an isoquinolinyl group, a benzoquinolinyl group, a benzoisoquinolinyl group, a quinoxalinyl group, a quinazolinyl group, a cinnolinyl group, a carbazolyl group, a phenanthrolinyl group, a phenanthridinyl group, a benzoimidazolyl group, a benzofuranyl group, a benzothiophenyl group, a benzosilolyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzofluorenyl group, a benzocarbazolyl group, a naphthobenzofuranyl group, a naphthobenzothiophenyl group, a naphthobenzosilolyl group, a dibenzofluorenyl group, a dibenzocarbazolyl group, a dinaphthofuranyl group, a dinaphthothiophenyl group, a dinaphthosilolyl group, an indenocarbazolyl group, an indolocarbazolyl group, a benzofuranocarbazolyl group, a benzothienocarbazolyl group, a benzosilolocarbazolyl group, an imidazopyridinyl group, an imidazopyrimidinyl group, -Si(Q₃₁)(Q₃₂)(Q₃₃), - N(Q₃₁)(Q₃₂), -B(Q₃₁)(Q₃₂), -C(=O)(Q₃₁), -S(=O)₂(Q₃₁), -P(=O)(Q₃₁)(Q₃₂), or any combination thereof; or
-Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂), and
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₂₀ alkyl group, a phenyl group, a biphenyl group, a pyridinyl group, a pyrimidinyl group, a pyridazinyl group, a pyrazinyl group, a triazinyl group, or any combination thereof.
In one or more embodiments, in Formula 1, R₁ to R₆ may each independently be: hydrogen, deuterium, -F, a cyano group, a C₁-C₂₀ alkyl group, or a C₁-C₂₀ alkoxy group;
a C₁-C₂₀ alkyl group or a C₁-C₂₀ alkoxy group, each substituted with deuterium, -F, -CD₃, -CD₂H, -CDH₂, -CF₃, -CF₂H, -CFH₂, a cyano group, or any combination thereof; or
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a C₁-C₂₀ alkylphenyl group, a naphthyl group, a fluorenyl group, a phenanthrenyl group, an anthracenyl group, a thiophenyl group, a furanyl group, an indenyl group, an isoindolyl group, an indolyl group, a carbazolyl group, a benzofuranyl group, a benzothiophenyl group, a benzosilolyl group, a dibenzofuranyl group, a dibenzothiophenyl group, a benzocarbazolyl group, a dibenzocarbazolyl group, a dibenzosilolyl group, a quinolinyl group, an isoquinolinyl group, a benzoquinolinyl group, a benzoisoquinolinyl group, a phenylpyridinyl group, a phenanthrolinyl group, a phenanthridinyl group, a benzoimidazolyl group, or a benzoxazolyl group, each unsubstituted or substituted with deuterium, -F, -CD₃, -CD₂H, -CDH₂, -CF₃, -CF₂H, -CFH₂, a cyano group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a terphenyl group, a C₁-C₂₀ alkylphenyl group, a naphthyl group, a fluorenyl group, a phenanthrenyl group, an anthracenyl group, a thiophenyl group, a furanyl group, an indenyl group, an isoindolyl group, an indolyl group, a carbazolyl group, a benzofuranyl group, a benzothiophenyl group, a benzosilolyl group, a dibenzofuranyl group, a dibenzothiophenyl group, a benzocarbazolyl group, a dibenzocarbazolyl group, a dibenzosilolyl group, a quinolinyl group, an isoquinolinyl group, a benzoquinolinyl group, a benzoisoquinolinyl group, a phenylpyridinyl group, a phenanthrolinyl group, a phenanthridinyl group, a benzoimidazolyl group, a benzoxazolyl group, or any combination thereof.

In one or more embodiments, in Formula 1, R₁ to R₆ may each independently be: hydrogen, deuterium, -F, a cyano group, or a C₁-C₂₀ alkyl group; or
a phenyl group, a biphenyl group, a terphenyl group, a C₁-C₂₀ alkylphenyl group, a naphthyl group, a fluorenyl group, a phenanthrenyl group, an anthracenyl group, a carbazolyl group, a dibenzofuranyl group, a dibenzothiophenyl group, a benzoquinolinyl group, a benzoisoquinolinyl group, a phenanthridinyl group, a benzoimidazolyl group, or a benzoxazolyl group, each unsubstituted or substituted with deuterium, -F, a cyano group, a C₁-C₂₀ alkyl group, a C₁-C₂₀ alkoxy group, a phenyl group, a biphenyl group, a terphenyl group, a C₁-C₂₀ alkylphenyl group, a naphthyl group, a fluorenyl group, a phenanthrenyl group, an anthracenyl group, a carbazolyl group, a dibenzofuranyl group, a dibenzothiophenyl group, a benzoquinolinyl group, a benzoisoquinolinyl group, a phenanthridinyl group, a benzoimidazolyl group, a benzoxazolyl group, or any combination thereof.

In one or more embodiments, in Formula 1, R₁ to R₄ may each independently be hydrogen, deuterium, -F, a cyano group, or a C₁-C₂₀ alkyl group, and
in Formula 1, R₅ and R₆ may each independently be a phenyl group, a biphenyl group, a terphenyl group, a C₁-C₂₀ alkylphenyl group, a naphthyl group, a fluorenyl group, a phenanthrenyl group, an anthracenyl group, a carbazolyl group, a dibenzofuranyl group, a dibenzothiophenyl group, a benzoquinolinyl group, a benzoisoquinolinyl group, a phenanthridinyl group, a benzoimidazolyl group, or a benzoxazolyl group, each unsubstituted or substituted with deuterium, -F, a cyano group, a C₁-C₂₀ alkyl group, a C₁-C₂₀ alkoxy group, a phenyl group, a biphenyl group, a terphenyl group, a C₁-C₂₀ alkylphenyl group, a naphthyl group, a fluorenyl group, a phenanthrenyl group, an anthracenyl group, a carbazolyl group, a dibenzofuranyl group, a dibenzothiophenyl group, a benzoquinolinyl group, a benzoisoquinolinyl group, a phenanthridinyl group, a benzoimidazolyl group, a benzoxazolyl group, or any combination thereof.

In one or more embodiments, Formula 1 may be represented by one of Formulae 1-1 to 1-4.

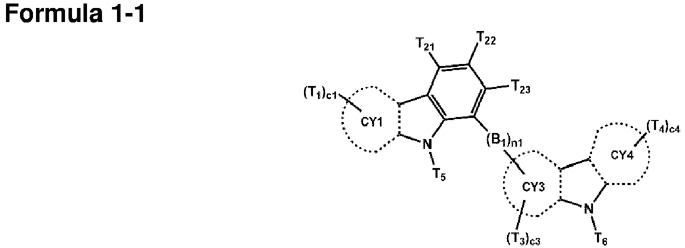

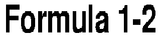

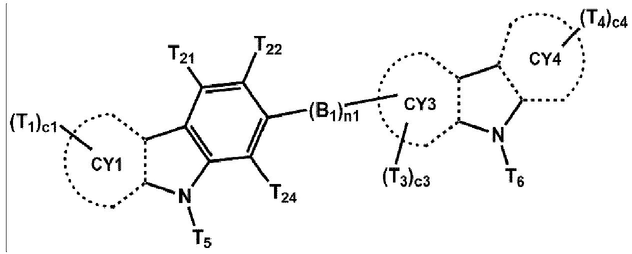

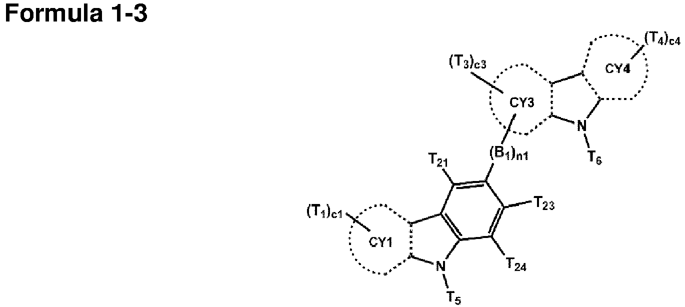

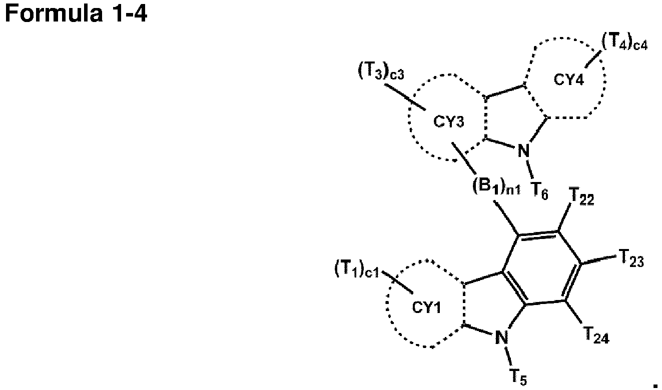

In Formulae 1-1 to 1-4,
CY1, CY3, CY4, T₁, T₃, T₄, T₅, T₆, c1, c3, c4, B₁ and n1 are each independently the same as described in the present specification,
T₂₁ is *-(L₂₁)ₐ₂₁-(R₂₁)_{b21},
T₂₂ is *-(L₂₂)ₐ₂₂-(R₂₂)_{b22},
T₂₃ is *-(L₂₃)ₐ₂₃-(R₂₃)_{b23},
T₂₄ is *-(L₂₄)ₐ₂₄-(R₂₄)_{b24},
* may indicate a binding site to a neighboring atom,
L₂₁ to L₂₄ are each independently the same as described in connection with L₂,
a21 to a24 are each independently the same as described in connection with a2,
R₂₁ to R₂₄ are each independently the same as explained in connection with R₂, and
b21 to b24 are each independently the same as described in connection with b2.

In one or more embodiments, Formula 1 may be represented by one of Formulae 1-5 to 1-14.

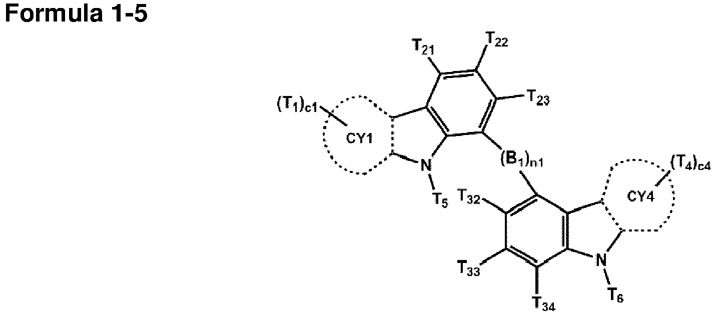

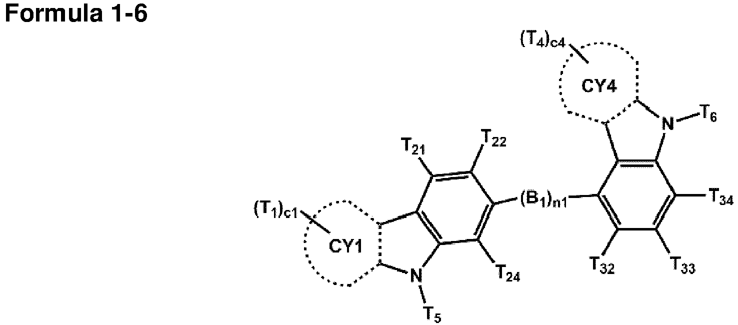

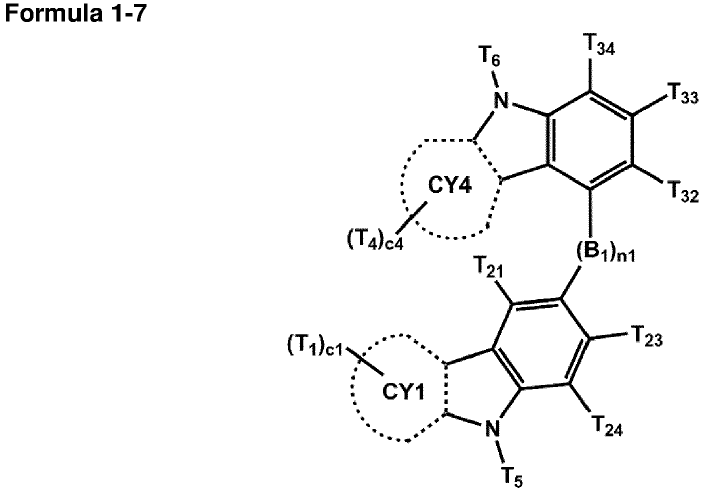

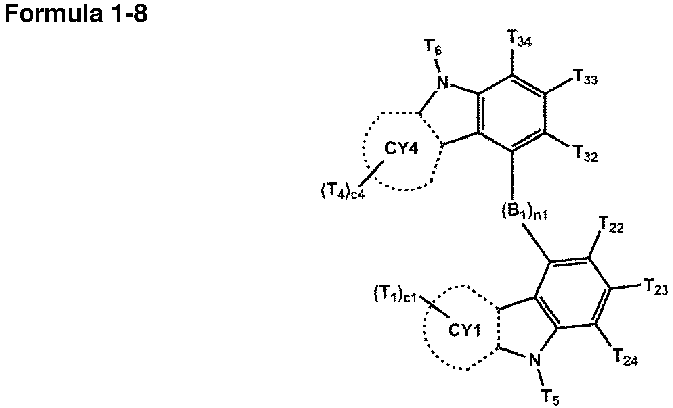

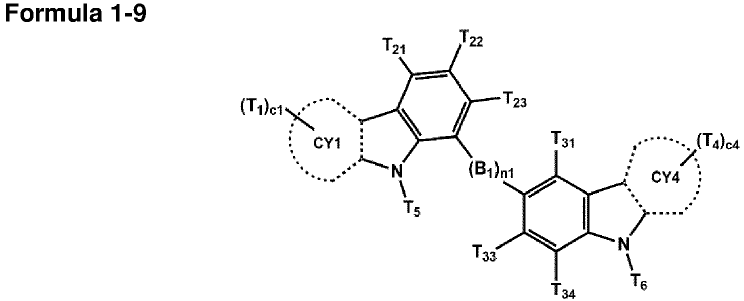

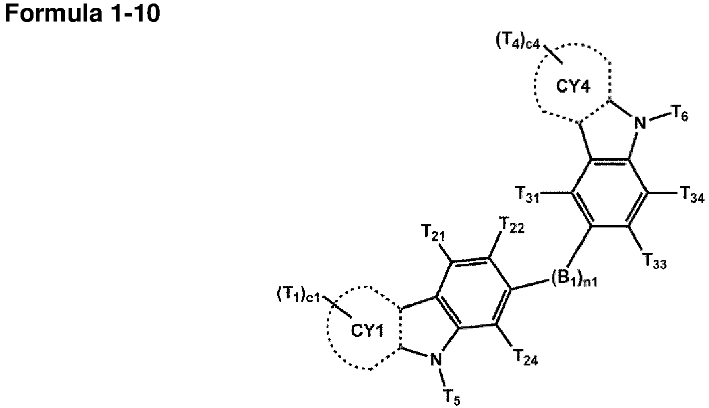

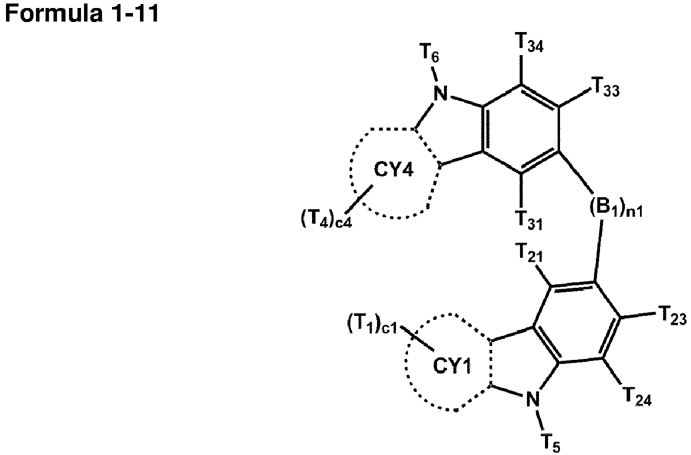

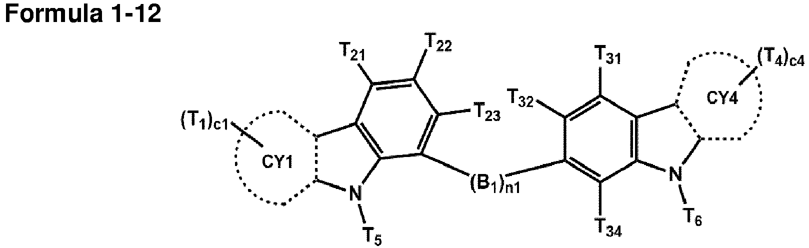

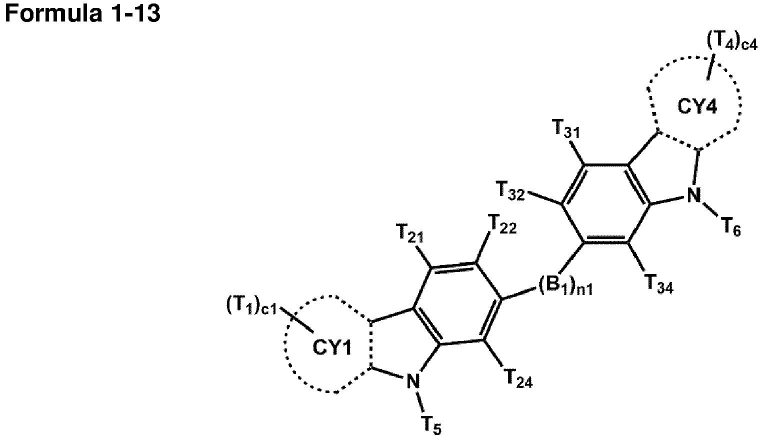

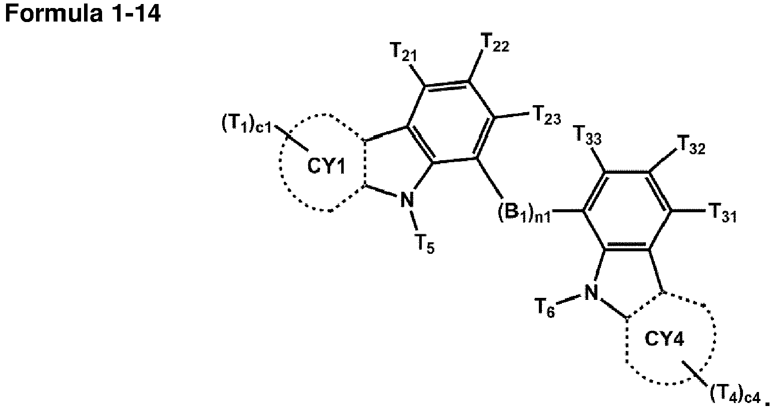

In Formulae 1-5 to 1-14,
CY1, CY4, T₁, T₄, T₅, T₆, c1, c4, B₁, and n1 may each independently be the same as described in the present specification,
T₂₁ may be *-(L₂₁)ₐ₂₁-(R₂₁)_{b21},
T₂₂ may be *-(L₂₂)ₐ₂₂-(R₂₂)_{b22},
T₂₃ may be *-(L₂₃)ₐ₂₃-(R₂₃)_{b23},
T₂₄ may be *-(L₂₄)ₐ₂₄-(R₂₄)_{b24},
T₃₁ may be *-(L₃₁)ₐ₃₁-(R₃₁)_{b31},
T₃₂ may be *-(L₃₂)ₐ₃₂-(R₃₂)_{b32},
T₃₃ may be *-(L₃₃)ₐ₃₃-(R₃₃)_{b33},
T₃₄ may be *-(L₃₄)ₐ₃₄-(R₃₄)_{b34},
* may indicate a binding site to a neighboring atom,
L₂₁ to L₂₄ may each independently be the same as described in connection with L₂,
L₃₁ to L₃₄ may each independently be the same as described in connection with L₃,
a21 to a24 may each independently be the same as described in connection with a2,
a31 to a34 may each independently be the same as described in connection with a3,
R₂₁ to R₂₄ may each independently be the same described in connection with R2,
R₃₁ to R₃₄ may each independently be the same as described in connection with R₃,
b21 to b24 may each independently be the same as described in connection with b2, and
b31 to b34 may each independently be the same as described in connection with b3.

In one or more embodiments, a hole mobility of the heterocyclic compound may be in a range of about 0.01 cm²/V·s to about 0.10 cm²/V·s. In one or more embodiments, a hole mobility of the heterocyclic compound may be in a range of about 0.04 cm²/V·s to about 0.06 cm²/V·s.

In one or more embodiments, the heterocyclic compound may be any one selected from Compounds 1-1 to 1-15:

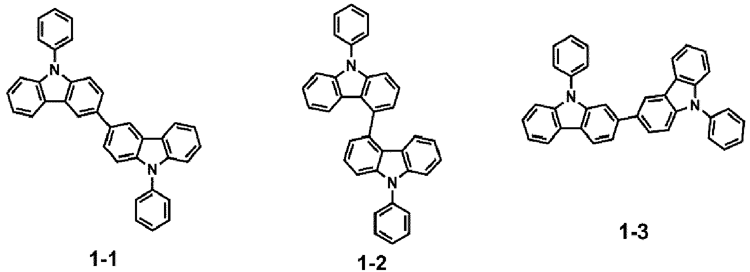

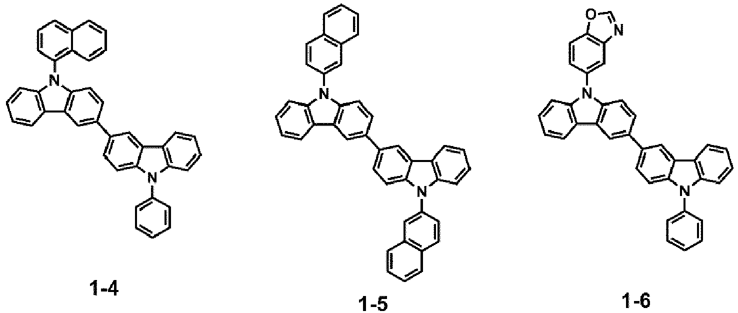

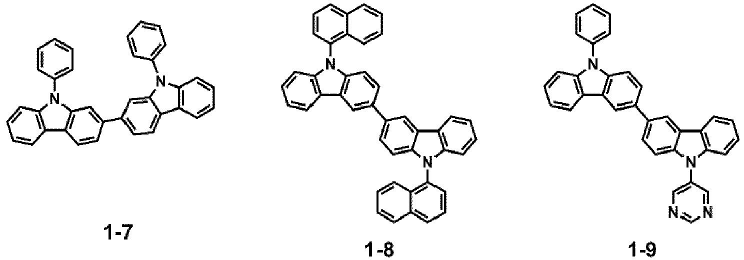

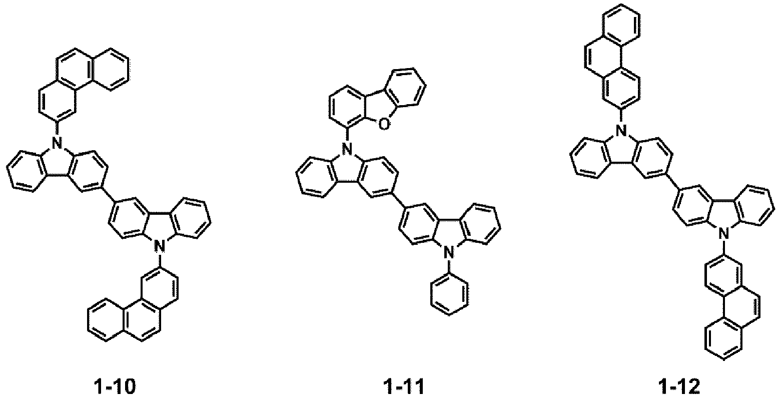

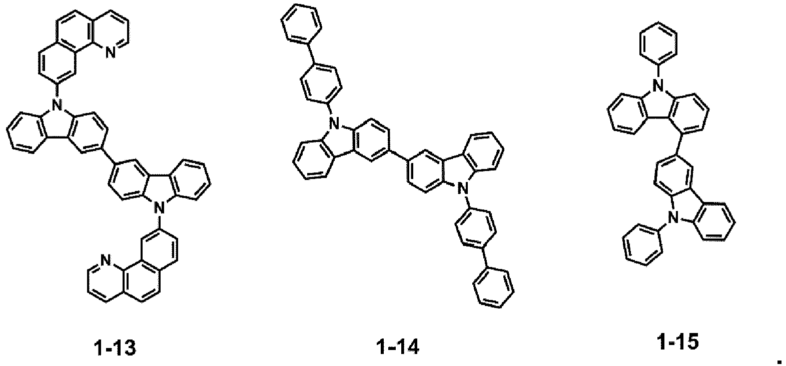

The light-emitting device according to the disclosure may include an electron blocking layer including the heterocyclic compound.

In one or more embodiments, the electron blocking layer including the heterocyclic compound may have improved hole mobility, and thus may improve driving voltage of the light-emitting device.

For example, the heterocyclic compound may be introduced into the electron blocking layer included in the light-emitting device including a plurality of emitting units, thereby further improving driving voltage of the light-emitting device.

Methods of synthesizing the heterocyclic compound may be able to be recognized by those of ordinary skill in the art by referring to Examples described herein.

In one or more embodiments, the first electrode may be an anode, and the second electrode may be a cathode.

In one or more embodiments, the light-emitting device may further include an electron transport region arranged between the emission layer and the second electrode.

The hole transport region may further include a hole injection layer, a hole transport layer, an emission auxiliary layer, or any combination thereof, in addition to the electron blocking layer.

In one or more embodiments, the electron blocking layer may be a part of and in direct contact with a suitable layer of the interlayer. Alternatively, in one or more embodiments, the electron blocking layer is not part of the interlayer and is in direct contact with the interlayer.

In one or more embodiments, the electron blocking layer may be in direct contact with the emission layer.

The electron transport region may include at least one layer selected from a buffer layer, a hole blocking layer, an electron control layer, an electron transport layer, and an electron injection layer.

The emission layer may be to emit red light, green light, blue light, and/or white light. In one or more embodiments, the emission layer may be to emit blue light. The blue light may have a maximum emission wavelength in a range of, for example, about 400 nm to about 490 nm. The blue light may have a maximum emission wavelength in a range of, for example, about 440 nm to about 470 nm.

In one or more embodiments, the emission layer may include a host and a dopant.

In one or more embodiments, the emission layer may include a phosphorescent dopant, a delayed fluorescence material, or a combination thereof. In one or more embodiments, the emission layer may further include a phosphorescent dopant, in addition to a host and a dopant.

In one or more embodiments, the dopant may include a transition metal and ligand(s) in the number of m, and m may be an integer from 1 to 6 The ligand(s) in the number of m may be identical to or different from each other, at least one of the ligand(s) in the number of m may be bound to the transition metal via a carbon-transition metal bond, and the carbon-transition metal bond may be a coordinate bond. For example, at least one of the ligand(s) in the number of m may be a carbene ligand (e.g., Ir(pmp)3 and/or the like). The transition metal may be, for example, iridium, platinum, osmium, palladium, rhodium, and/or gold. The emission layer and the dopant may respectively be understood by referring to the descriptions of the emission layer and the dopant provided herein.

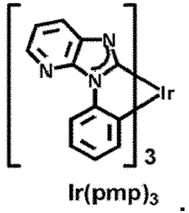

In one or more embodiments, the light-emitting device may include: m emitting units arranged between the first electrode and a suitable layer of the interlayer, m-1 charge-generating unit(s) arranged between neighboring emitting units among the m emitting units, and a charge-generating unit arranged between an emitting unit adjacent to the suitable layer of the interlayer among the m emitting units and the suitable layer of the interlayer; n emitting units arranged between the second electrode and a suitable layer of the interlayer, n-1 charge-generating unit(s) arranged between neighboring emitting units among the n emitting units, and a charge-generating unit arranged between an emitting unit adjacent to the suitable layer of the interlayer among the n emitting units and the suitable layer of the interlayer; or a combination thereof.

In one or more embodiments, the emitting unit may include an emission layer. In one or more embodiments, the charge-generating unit may include an n-type charge generation layer (e.g., an N-charge generation layer) and a p-type charge generation layer (e.g., a P-charge generation layer).

In one or more embodiments, m and n may each independently be an integer from 1 to 3.

In one or more embodiments, when m is 1, the first electrode, a first emitting unit, a first charge-generating unit, and the suitable layer of the interlayer may be sequentially arranged. In one or more embodiments, when m is 2, the first electrode, a first emitting unit, a first charge-generating unit, a second emitting unit, a second charge-generating unit, and the suitable layer of the interlayer may be sequentially arranged. In one or more embodiments, when m is 3, the first electrode, a first emitting unit, a first charge-generating unit, a second emitting unit, a second charge-generating unit, a third emitting unit, a third charge-generating unit, and the suitable layer of the interlayer may be sequentially arranged.

In this regard, the first emitting unit may be to emit first-color light, the second emitting unit may be to emit second-color light, the third emitting unit may be to emit third-color light, and a maximum emission wavelength of first-color light, a maximum emission wavelength of second-color light, and a maximum emission wavelength of third-color light may be identical to or different from each other.

In one or more embodiments, the electron blocking layer may be arranged between the first electrode and the first emitting unit, between the second emitting unit and the first charge-generating unit, between the third emitting unit and the second charge-generating unit, between the third charge-generating unit and the suitable layer of the interlayer, or in any combination thereof.

In one or more embodiments, when n is 1, the suitable layer of the interlayer, a fourth charge-generating unit, a fourth emitting unit, and the second electrode may be sequentially arranged. In one or more embodiments, when n is 2, the suitable layer of the interlayer, a fourth charge-generating unit, a fourth emitting unit, a fifth charge-generating unit, a fifth emitting unit, and the second electrode may be sequentially arranged. In one or more embodiments, when n is 3, the suitable layer of the interlayer, a fourth charge-generating unit, a fourth emitting unit, a fifth charge-generating unit, a fifth emitting unit, a sixth charge-generating unit, a sixth emitting unit, and the second electrode may be sequentially arranged.

In this regard, the fourth emitting unit may be to emit fourth-color light, the fifth emitting unit may be to emit fifth-color light, the sixth emitting unit may be to emit sixth-color light, and a maximum emission wavelength of fourth-color light, a maximum emission wavelength of fifth-color light, and a maximum emission wavelength of sixth-color light may be identical to or different from each other.

In one or more embodiments, the electron blocking layer may be arranged between the fourth charge-generating unit and the fourth emitting unit, between the fifth charge-generating unit and the fifth emitting unit, between the sixth charge-generating unit and the sixth emitting unit, or in any combination thereof.

In one or more embodiments, at least one of the m emitting units or the n emitting units may be to emit blue light.

In one or more embodiments, the electron blocking layer may be arranged between the at least one emitting unit emitting (e.g., configured to emit) blue light and the first electrode, and the electron blocking layer may be in direct contact with the at least one emitting unit emitting (e.g., configured to emit) blue light. In this case, when an emitting unit emitting (e.g., configured to emit) blue light is provided in a multiple number, the light-emitting device may include the emitting units emitting (e.g., configured to emit) blue light and a plurality of electron blocking layers that are in direct contact with the emitting units.

In one or more embodiments, at least one of the m emitting units or the n emitting units may be to emit green light.

In one or more embodiments, the at least one emitting unit emitting (e.g., configured to emit) green light and the electron blocking layer may not be in direct contact with each other. In one or more embodiments, an emitting unit emitting (e.g., configured to emit) green light may not include (e.g., may exclude) the electron blocking layer.

In one or more embodiments, at least one of the m emitting units or the n emitting units may be to emit green light, and the remaining emitting units may be to emit blue light.

In one or more embodiments, an emitting unit adjacent to the second electrode among the m emitting units or the n emitting units may be to emit green light, and the remaining emitting units may be to emit blue light.

An electronic apparatus according to one or more embodiments includes the light-emitting device.

In one or more embodiments, the electron apparatus may further include a thin-film transistor,

the thin-film transistor may include a source electrode and a drain electrode, and

the first electrode of the light-emitting device may be electrically connected to at least one of the source electrode or the drain electrode of the thin-film transistor.

In one or more embodiments, the electronic apparatus may further include a color filter, a color conversion layer, a touch screen layer, a polarizing layer, or any combination thereof.

In one or more embodiments, the electronic apparatus may further include quantum dots. In one or more embodiments, the electronic apparatus may include a color conversion layer, and the color conversion layer may include quantum dots.

The term "interlayer" as utilized herein refers to a single layer and/or all of a plurality of layers arranged between the first electrode and the second electrode of the light-emitting device.

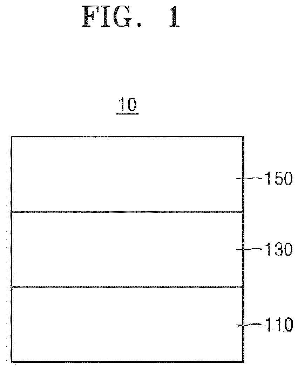

### Description of FIG. 1

FIG. 1 is a schematic cross-sectional view of a light-emitting device 10 according to one or more embodiments of the disclosure. The light-emitting device 10 includes a first electrode 110, an interlayer 130, and a second electrode 150.

Hereinafter, a structure of the light-emitting device 10 according to one or more embodiments and a method of manufacturing the light-emitting device 10 will be described in connection with FIG. 1.

### First electrode 110

In FIG. 1, a substrate may be additionally located under the first electrode 110 or above the second electrode 150. As the substrate, a glass substrate and/or a plastic substrate may be utilized. In one or more embodiments, the substrate may be a flexible substrate, and may include plastics with excellent or suitable heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high work function material that facilitates injection of holes.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide (SnO₂), zinc oxide (ZnO), or any combination thereof. In one or more embodiments, when the first electrode 110 is a semi-transmissive electrode or a reflective electrode, magnesium (Mg), silver (Ag), aluminum (Al), aluminum-lithium (Al-Li), calcium (Ca), magnesium-indium (Mg-In), magnesium-silver (Mg-Ag), or any combination thereof may be utilized as a material for forming a first electrode.

The first electrode 110 may have a single-layered structure including (e.g., consisting of) a single layer or a multilayer structure including a plurality of layers. In one or more embodiments, the first electrode 110 may have a three-layered structure of ITO/Ag/ITO.

### Interlayer 130

The interlayer 130 may be located on the first electrode 110. The interlayer 130 may include an emission layer.

The interlayer 130 may further include a hole transport region between the first electrode 110 and the emission layer, and an electron transport region between the emission layer and the second electrode 150.

The interlayer 130 may further include metal-containing compounds such as organometallic compounds, inorganic materials such as quantum dots, and/or the like, in addition to one or more suitable organic materials.

In one or more embodiments, the interlayer 130 may include, i) two or more emitting units sequentially stacked between the first electrode 110 and the second electrode 150, and ii) a charge generation layer located between the two emitting units. When the interlayer 130 includes emitting units and a charge generation layer as described above, the light-emitting device 10 may be a tandem light-emitting device.

### Hole transport region in interlayer 130

The hole transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The hole transport region may include an electron blocking layer.

The hole transport region may further include a hole injection layer, a hole transport layer, an emission auxiliary layer, or any combination thereof.

In one or more embodiments, the hole transport region may have a multi-layered structure including a hole injection layer/hole transport layer/emission auxiliary layer/electron blocking layer structure, a hole injection layer/emission auxiliary layer/electron blocking layer structure, a hole transport layer/emission auxiliary layer/electron blocking layer structure, or a hole injection layer/hole transport layer/electron blocking layer structure, the layers of each structure being stacked sequentially from the first electrode 110.

The hole transport region may include a compound represented by Formula 201, a compound represented by Formula 202, or any combination thereof: 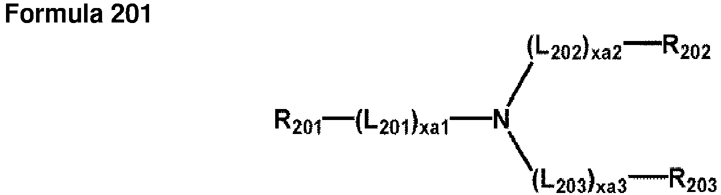 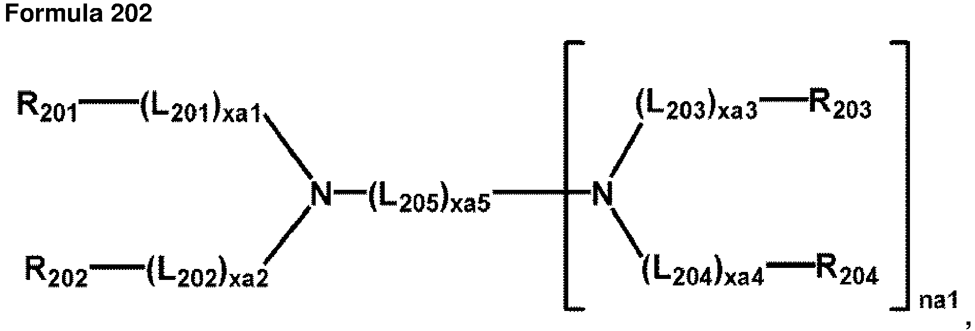 wherein, in Formulae 201 and 202,
L₂₀₁ to L₂₀₄ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
L₂₀₅ may be *-O-*', *-S-*', *-N(Q₂₀₁)-*', a C₁-C₂₀ alkylene group that is unsubstituted or substituted with at least one R₁₀ₐ, a C₂-C₂₀ alkenylene group that is unsubstituted or substituted with at least one R₁₀ₐ, a C₃-C₆₀ carbocyclic group that is unsubstituted or substituted with at least one R₁₀ₐ, or a C₁-C₆₀ heterocyclic group that is unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
R₂₀₁ and R₂₀₂ may optionally be linked to each other via a single bond, a C₁-C₅ alkylene group that is unsubstituted or substituted with at least one R₁₀ₐ, or a C₂-C₅ alkenylene group that is unsubstituted or substituted with at least one R₁₀ₐ to form a C₃-C₆₀ polycyclic group (for example, a carbazole group and/or the like) unsubstituted or substituted with at least one R₁₀ₐ (for example, Compound HT16),
R₂₀₃ and R₂₀₄ may optionally be linked to each other via a single bond, a C₁-C₅ alkylene group that is unsubstituted or substituted with at least one R₁₀ₐ, or a C₂-C₅ alkenylene group that is unsubstituted or substituted with at least one R₁₀ₐ to form a C₃-C₆₀ polycyclic group that is unsubstituted or substituted with at least one R₁₀ₐ, and
na1 may be an integer from 1 to 4.

In one or more embodiments, each of Formulae 201 and 202 may include at least one of groups represented by Formulae CY201 to CY217: 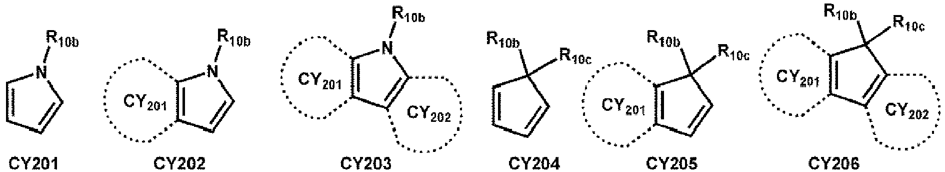 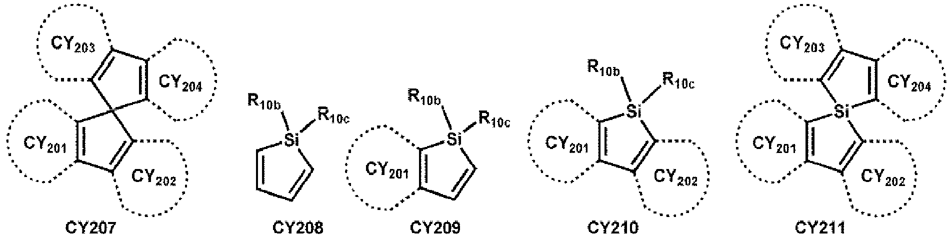 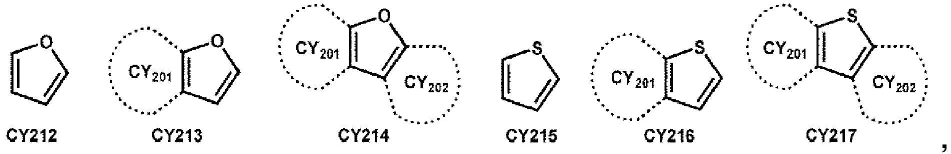 wherein, in Formulae CY201 to CY217, R_{10b} and R₁₀ₑ may each independently be the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ as described above.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one of groups represented by Formulae CY201 to CY203.

In one or more embodiments, Formula 201 may include at least one of groups represented by Formulae CY201 to CY203 and at least one of groups represented by Formulae CY204 to CY217.

In one or more embodiments, xa1 in Formula 201 may be 1, R₂₀₁ may be a group represented by one of Formulae CY201 to CY203, xa2 may be 0, and R₂₀₂ may be a group represented by one of Formulae CY204 to CY207.

In one or more embodiments, each of Formulae 201 and 202 may not include (e.g., may exclude) groups represented by Formulae CY201 to CY203.

In one or more embodiments, each of Formulae 201 and 202 may not include (e.g., may exclude) groups represented by Formulae CY201 to CY203, and may include at least one of groups represented by Formulae CY204 to CY217.

In one or more embodiments, each of Formulae 201 and 202 may not include (e.g., may exclude) groups represented by Formulae CY201 to CY217.

In one or more embodiments, the hole transport region may include one or more of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzene sulfonic acid (PANI/DBSA), poly(3,4-ethylene dioxythiophene)/poly(4-styrene sulfonate) (PEDOT/PSS), polyaniline/camphor sulfonic acid (PANI/CSA), polyaniline/poly(4-styrene sulfonate) (PANI/PSS), or any combination thereof:

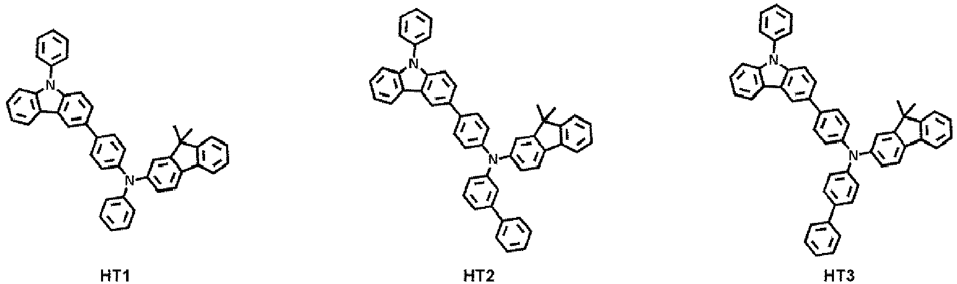

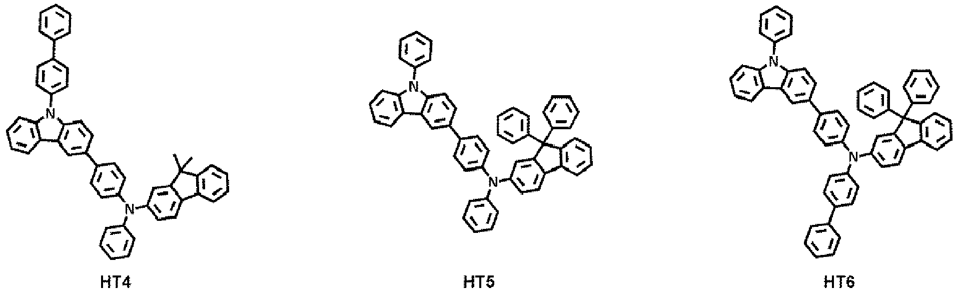

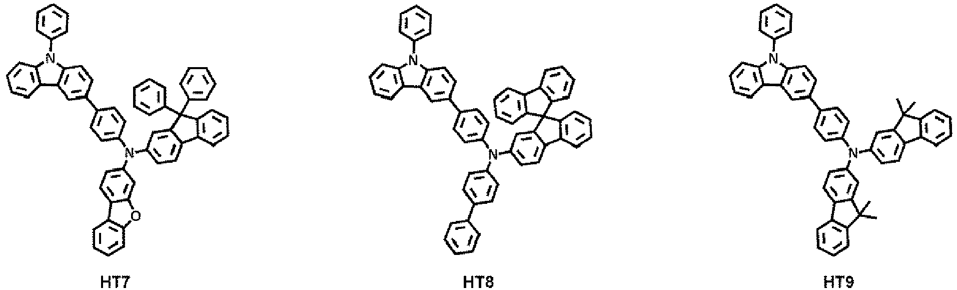

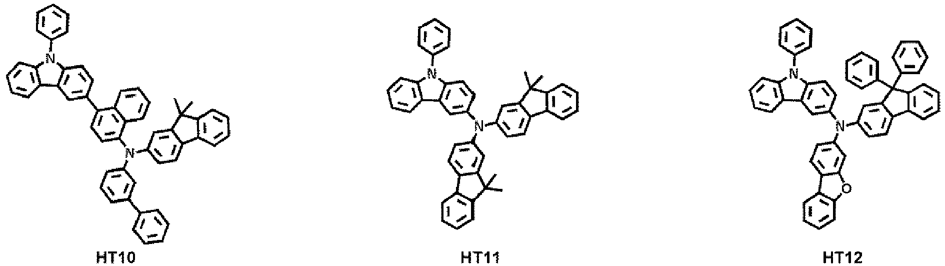

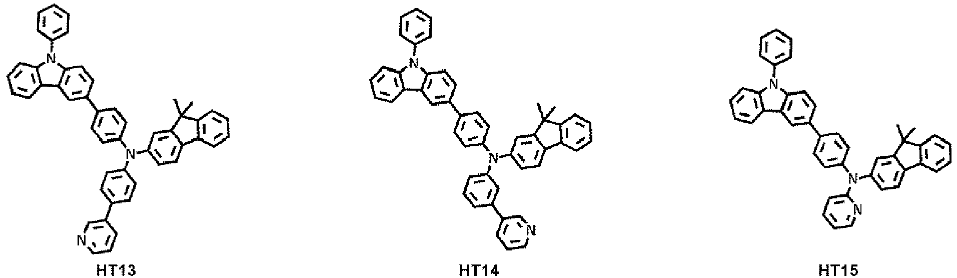

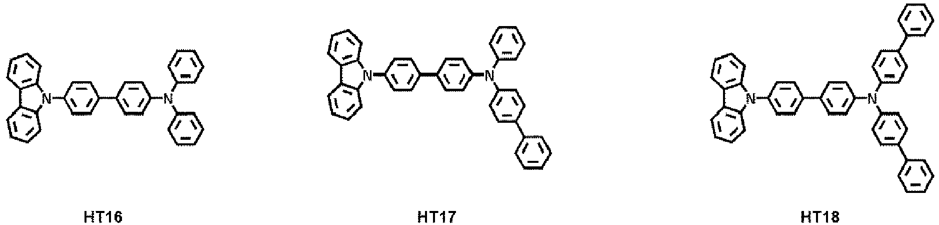

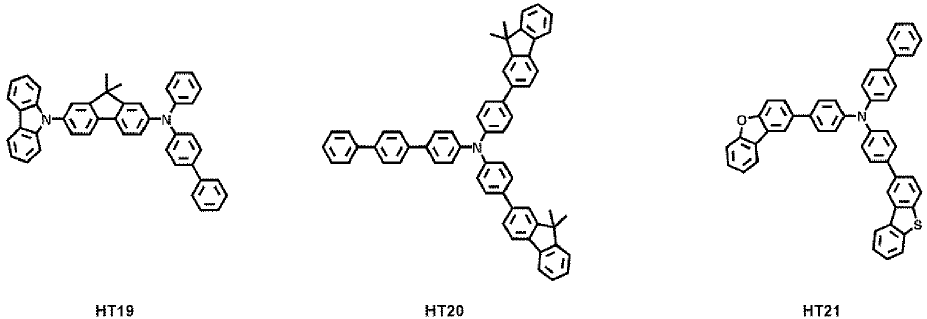

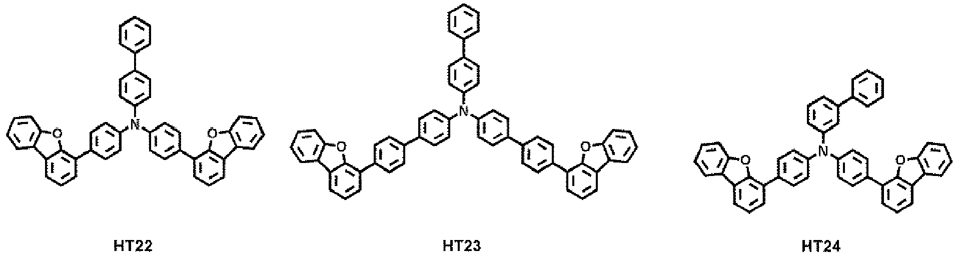

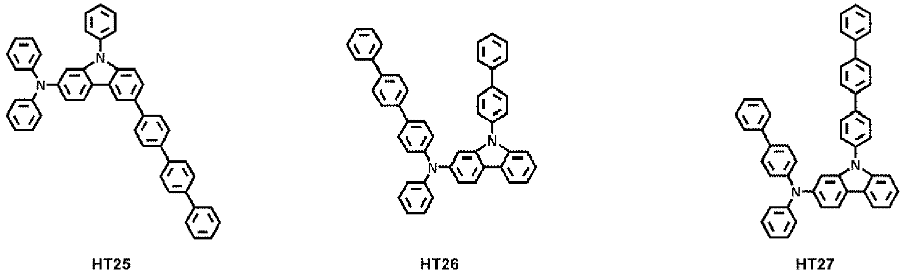

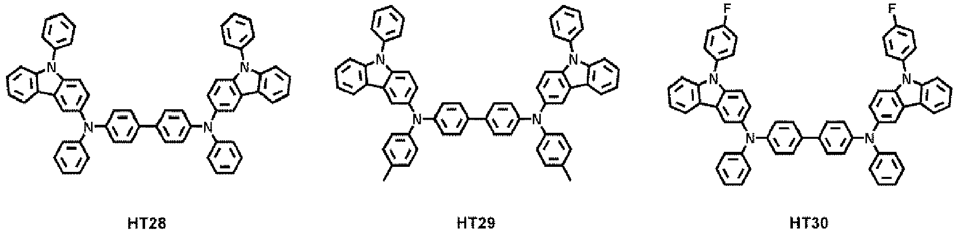

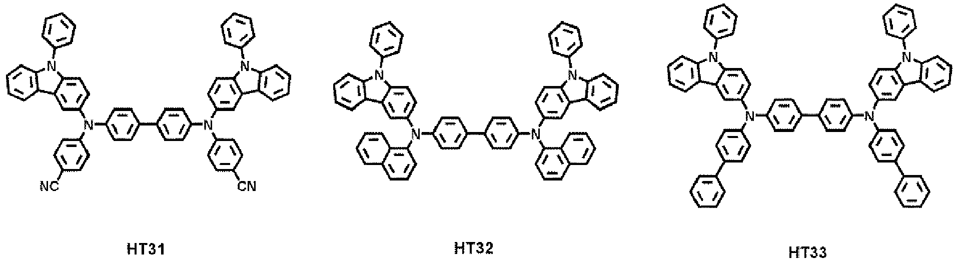

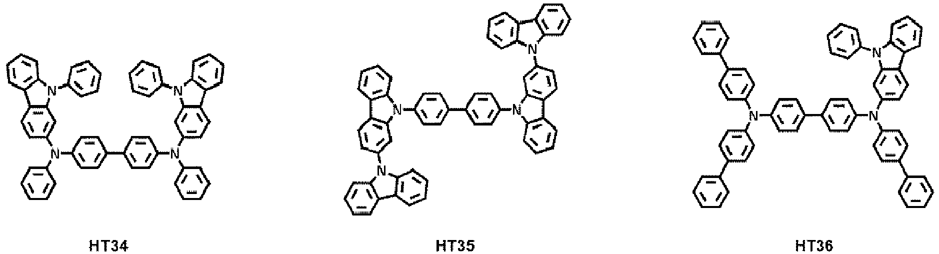

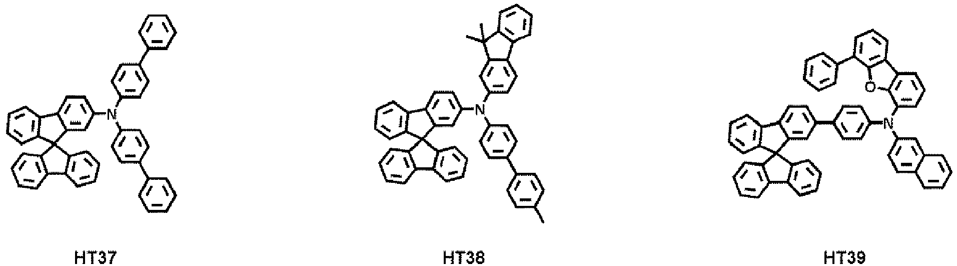

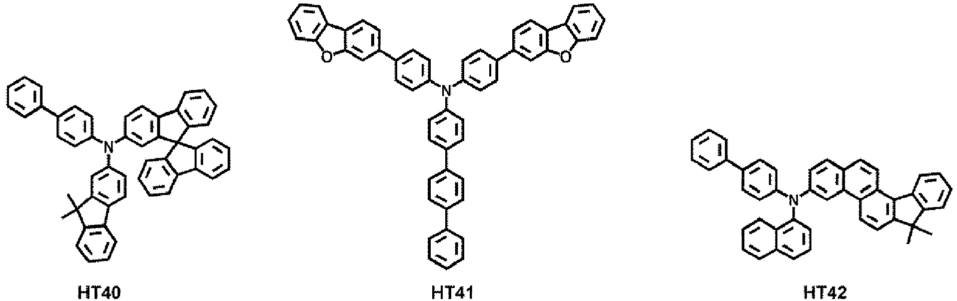

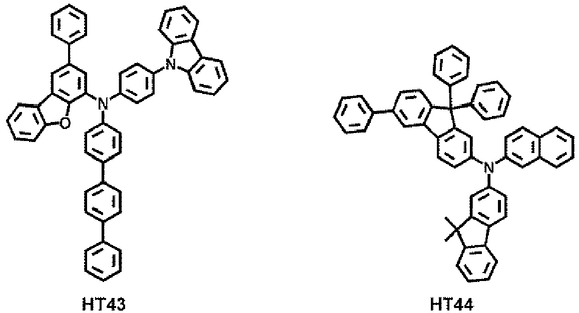

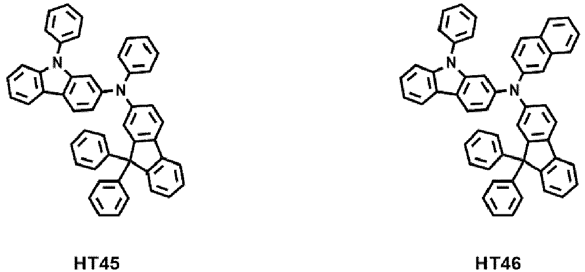

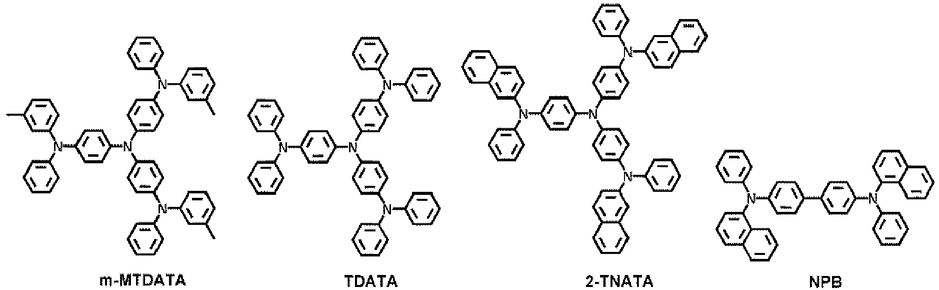

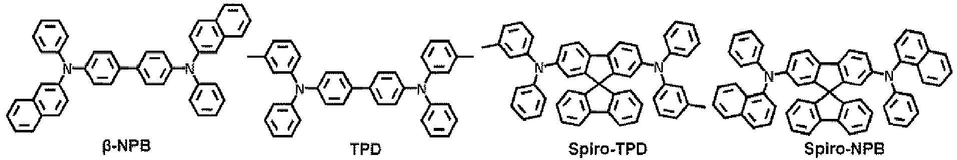

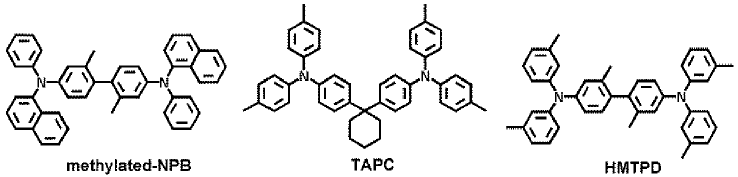

A thickness of the hole transport region may be in a range of about 50 Å to about 10,000 Å, for example, about 100 Å to about 4,000 Å. When the hole transport region includes a hole injection layer, a hole transport layer, or any combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer and/or the hole transport layer are within any of their respective ranges, satisfactory or suitable hole-transporting characteristics may be obtained without a substantial increase in driving voltage.

The emission auxiliary layer may increase light-emission efficiency by compensating for an optical resonance distance of the wavelength of light emitted from the emission layer, and the electron blocking layer may block or reduce the leakage of electrons from the emission layer to the hole transport region.

The electron blocking layer may include the heterocyclic compound represented by Formula 1.

Material(s) that may be included in the hole transport region may be included in the emission auxiliary layer. Material(s) that may be included in the hole transport region may be further included in the electron blocking layer.

### p-dopant

The hole transport region may further include, in addition to the materials described above, a charge-generation material for the improvement of conductive properties. The charge-generation material may be uniformly or non-uniformly dispersed in the hole transport region (for example, in the form of a single layer including (e.g., consisting of) a charge-generation material).

The charge-generation material may be, for example, a p-dopant.

In one or more embodiments, a LUMO energy level of the p-dopant may be about -3.5 eV or less.

In one or more embodiments, the p-dopant may include a quinone derivative, a cyano group-containing compound, a compound containing an element EL1 and an element EL2, or any combination thereof.

Examples of the quinone derivative may include TCNQ, F4-TCNQ, and the like.

Examples of the cyano group-containing compound may include HAT-CN, a compound represented by Formula 221, and the like.

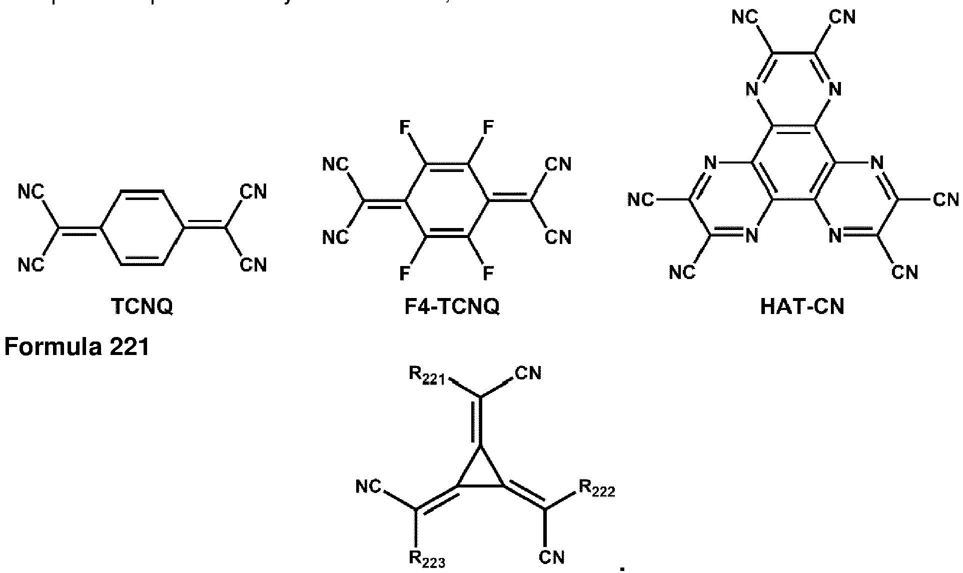

In Formula 221,
R₂₂₁ to R₂₂₃ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, -I, or any combination thereof; or any combination thereof.

In the compound containing the element EL1 and the element EL2, the element EL1 may be a metal, a metalloid, or a combination thereof, and the element EL2 may be a non-metal, a metalloid, or a combination thereof.

Examples of the metal may include: an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of the metalloid may include silicon (Si), antimony (Sb), and tellurium (Te).

Examples of the non-metal may include oxygen (O) and halogen (for example, F, Cl, Br, I, etc.).

In one or more embodiments, examples of the compound containing the element EL1 and the element EL2 may include metal oxide, metal halide (for example, metal fluoride, metal chloride, metal bromide, and/or metal iodide), metalloid halide (for example, metalloid fluoride, metalloid chloride, metalloid bromide, and/or metalloid iodide), metal telluride, or any combination thereof.

Examples of the metal oxide may include tungsten oxide (for example, WO, W₂O₃, WO₂, WO₃, W₂O₅, etc.), vanadium oxide (for example, VO, V₂O₃, VO₂, V₂O₅, etc.), molybdenum oxide (MoO, Mo₂O₃, MoO₂, MoOs, Mo₂O₅, etc.), and rhenium oxide (for example, ReO₃, etc.).

Examples of the metal halide may include alkali metal halide, alkaline earth metal halide, transition metal halide, post-transition metal halide, and lanthanide metal halide.

Examples of the alkali metal halide may include LiF, NaF, KF, RbF, CsF, LiCI, NaCl, KCI, RbCI, CsCI, LiBr, NaBr, KBr, RbBr, CsBr, Lil, Nal, KI, Rbl, and Csl.

Examples of the alkaline earth metal halide may include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, and Bate.

Examples of the transition metal halide may include titanium halide (for example, TiF₄, TiCla, TiBr₄, TiI₄, etc.), zirconium halide (for example, ZrF₄, ZrCl₄, ZrBr₄, ZrI₄, etc.), hafnium halide (for example, HfF₄, HfCl₄, HfBr₄, HfI₄, etc.), vanadium halide (for example, VF₃, VCl₃, VBr₃, VI₃, etc.), niobium halide (for example, NbF₃, NbCl₃, NbBr₃, NbI₃, etc.), tantalum halide (for example, TaF₃, TaCl₃, TaBr₃, TaI₃, etc.), chromium halide (for example, CrF₃, CrCl₃, CrBr₃, CrI₃, etc.), molybdenum halide (for example, MoF₃, MoCb, MoBr₃, MoI₃, etc.), tungsten halide (for example, WF₃, WCl₃, WBr₃, WI₃, etc.), manganese halide (for example, MnF₂, MnCl₂, MnBr₂, MnI₂, etc.), technetium halide (for example, TcF₂, TcCl₂, TcBr₂, TcI₂, etc.), rhenium halide (for example, ReF₂, ReCl₂, ReBr₂, ReI₂, etc.), ferrous halide (for example, FeF₂, FeCl₂, FeBr₂, FeI₂, etc.), ruthenium halide (for example, RuF₂, RuCl₂, RuBr₂, RuI₂, etc.), osmium halide (for example, OsF₂, OsCl₂, OsBr₂, OsI₂, etc.), cobalt halide (for example, CoF₂, CoCl₂, CoBr₂, Cote, etc.), rhodium halide (for example, RhF₂, RhCl₂, RhBr₂, RhI₂, etc.), iridium halide (for example, IrF₂, IrCl₂, IrBr₂, IrI₂, etc.), nickel halide (for example, NiF₂, NiCl₂, NiBr₂, NiI₂, etc.), palladium halide (for example, PdF₂, PdCl₂, PdBr₂, PdI₂, etc.), platinum halide (for example, PtF₂, PtCl₂, PtBr₂, PtI₂, etc.), cuprous halide (for example, CuF, CuCI, CuBr, Cul, etc.), silver halide (for example, AgF, AgCl, AgBr, Agl, etc.), and gold halide (for example, AuF, AuCI, AuBr, Aul, etc.).

Examples of the post-transition metal halide may include zinc halide (for example, ZnF₂, ZnCl₂, ZnBr₂, ZnI₂, etc.), indium halide (for example, InI₃, etc.), and tin halide (for example, SnI₂, etc.).

Examples of the lanthanide metal halide may include YbF, YbF₂, YbF₃, SmF₃, YbCl, YbCl₂, YbCl₃, SmCl₃, YbBr, YbBr₂, YbBr₃, SmBr₃, Ybl, YbI₂, YbI₃, and SmI₃.

Examples of the metalloid halide may include antimony halide (for example, SbCl₅, etc.).

Examples of the metal telluride may include alkali metal telluride (for example, Li₂Te, Na₂Te, K₂Te, Rb₂Te, Cs₂Te, etc.), alkaline earth metal telluride (for example, BeTe, MgTe, CaTe, SrTe, BaTe, etc.), transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal telluride (for example, ZnTe, etc.), and lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### Emission layer in interlayer 130

When the light-emitting device 10 is a full-color light-emitting device, the emission layer may be patterned into a red emission layer, a green emission layer, and/or a blue emission layer, according to a sub-pixel. At least one emission layer may include a quantum dot as described above. In one or more embodiments, the green emission layer may be a quantum dot emission layer including the quantum dot, and the blue emission layer and the red emission layer may each be an organic emission layer each including an organic compound.

In one or more embodiments, the emission layer may have a structure in which at least two of the red emission layer, the green emission layer, and the blue emission layer may contact each other or may be separated from each other. At least one emission layer of the two or more emission layers may be a quantum-dot emission layer including the quantum dot, and the remaining emission layer(s) may be each independently an organic emission layer including an organic compound. Other suitable modifications are possible.

### Electron transport region in interlayer 130

The electron transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron transport region may further include a metal oxide layer.

In one or more embodiments, the electron transport region may include, for example, ZnO, TiO₂, WO₃, SnO₂, In₂O₃, Nb₂O₅, Fe₂O₃, CeO₂, SrTiO₃, Zn₂SnO₄, BaSnO₃, In₂S₃, ZnSiO, PC60BM, PC70BM, Mg-doped ZnO (ZnMgO), Al-doped ZnO (AZO), Ga-doped ZnO (GZO), In-doped ZnO (IZO), Al-doped TiO₂, Ga-doped TiO₂, In-doped TiO₂, Al-doped WO₃, Ga-doped WO₃, In-doped WO₃, Al-doped SnO₂, Ga-doped SnO₂, In-doped SnO₂, Mg-doped In₂O₃, Al-doped In₂O₃, Ga-doped In₂O₃, Mg-doped Nb₂O₅, Al-doped Nb₂O₅, Ga-doped Nb₂O₅, Mg-doped Fe₂O₃, Al-doped Fe₂O₃, Ga-doped Fe₂O₃, In-doped Fe₂O₃, Mg-doped CeO₂, Al-doped CeO₂, Ga-doped CeO₂, In-doped CeO₂, Mg-doped SrTiO₃, Al-doped SrTiO₃, Ga-doped SrTiO₃, In-doped SrTiO₃, Mg-doped Zn₂SnO₄, Al-doped Zn₂SnO₄, Ga-doped Zn₂SnO₄, In-doped Zn₂SnO₄, Mg-doped BaSnO₃, Al-doped BaSnO₃, Ga-doped BaSnO₃, In-doped BaSnO₃, Mg-doped In₂S₃, Al-doped In₂S₃, Ga-doped In₂S₃, In-doped In₂S₃, Mg-doped ZnSiO, Al-doped ZnSiO, Ga-doped ZnSiO, In-doped ZnSiO, or any combination thereof.

The electron transport region may include a buffer layer, a hole blocking layer, an electron control layer, an electron transport layer, an electron injection layer, or any combination thereof. In one or more embodiments, the buffer layer, the hole blocking layer, the electron control layer, the electron transport layer, and/or the electron injection layer may each be the metal oxide layer, or any combination of at least one layer of the buffer layer, the hole blocking layer, the electron control layer, or the electron transport layer may be the metal oxide layer.

In one or more embodiments, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein, for each structure, constituting layers are sequentially stacked from the emission layer.

In one or more embodiments, the electron transport region (for example, the buffer layer, the hole blocking layer, the electron control layer, and/or the electron transport layer in the electron transport region) may include a metal-free compound including at least one π electron-deficient nitrogen-containing C₁-C₆₀ cyclic group.

In one or more embodiments, the electron transport region may include a compound represented by Formula 601:

**Formula 601** [Ar₆₀₁]ₓₑ₁₁-[(L₆₀₁)ₓₑ₁- R₆₀₁]ₓₑ₂₁,

wherein, in Formula 601,
Ar₆₀₁, and L₆₀₁ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group that is unsubstituted or substituted with at least one R₁₀ₐ, a C₁-C₆₀ heterocyclic group that is unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or - P(=O)(Q₆₀₁)(Q₆₀₂),
Q₆₀₁ to Q₆₀₃ may each independently be the same as described in connection with Q₁,
xe21 may be 1, 2, 3, 4, or 5, and
at least one of Ar₆₀₁, L₆₀₁, or R₆₀₁ may each independently be a π electron-deficient nitrogen-containing C₁-C₆₀ cyclic group that is unsubstituted or substituted with at least one R₁₀ₐ.

In one or more embodiments, when xe11 in Formula 601 is 2 or more, two or more of Ar₆₀₁(s) may be linked via a single bond.

In one or more embodiments, Ar₆₀₁ in Formula 601 may be a substituted or unsubstituted anthracene group.

In one or more embodiments, the electron transport region may include a compound represented by Formula 601-1 : 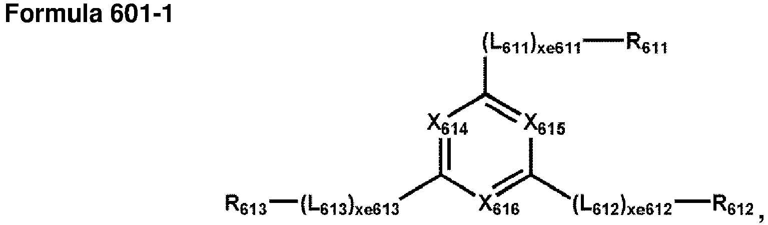 wherein, in Formula 601-1,
X₆₁₄ may be N or C(R₆₁₄), X₆₁₆ may be N or C(R₆₁₆), X₆₁₆ may be N or C(R₆₁₆), and at least one of X₆₁₄ to X₆₁₆ may be N,
L₆₁₁ to L₆₁₃ may each independently be the same as described in connection with L₆₀₁,
xe611 to xe613 may each independently be the same as described in connection with xe1,
R₆₁₁ to R₆₁₃ may each independently be the same as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group that is unsubstituted or substituted with at least one R₁₀ₐ, or a C₁-C₆₀ heterocyclic group that is unsubstituted or substituted with at least one R₁₀ₐ.

In one or more embodiments, xe1 and xe611 to xe613 in Formulae 601 and 601-1 may each independently be 0, 1, or 2.

The electron transport region may include one or more of Compounds ET1 to ET45, 2,9-dimethyl-4,7-diphenyl-1,10-phenanthroline (BCP), 4,7-diphenyl-1,10-phenanthroline (Bphen), Alq₃, BAIq, TAZ, NTAZ, or any combination thereof:

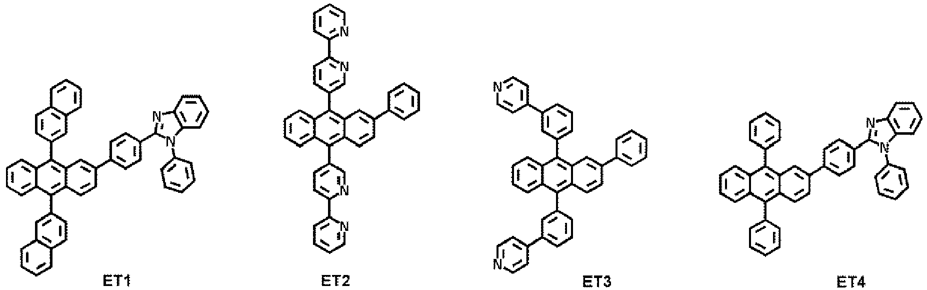

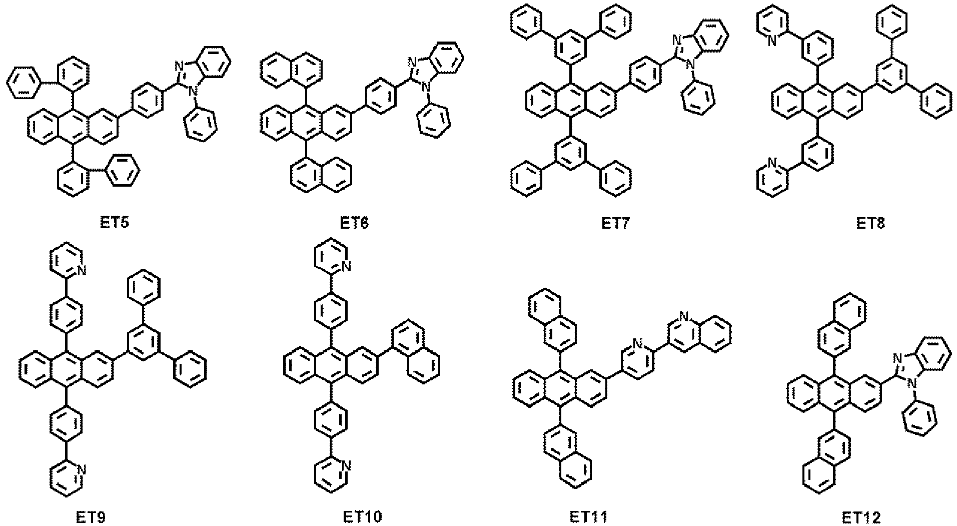

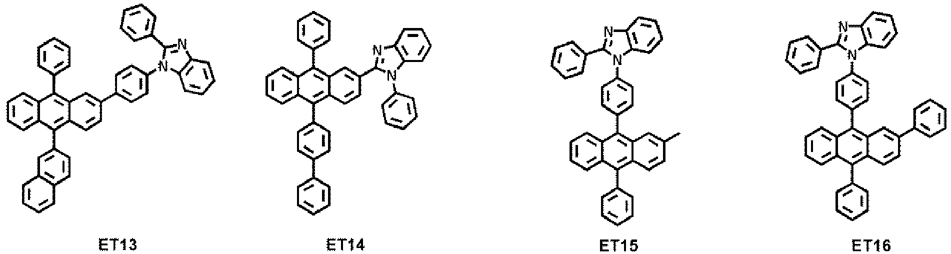

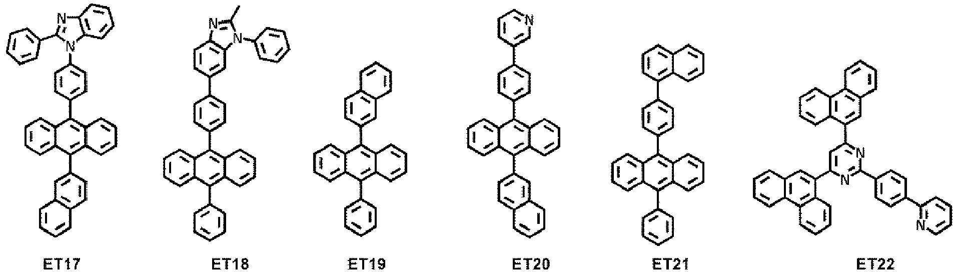

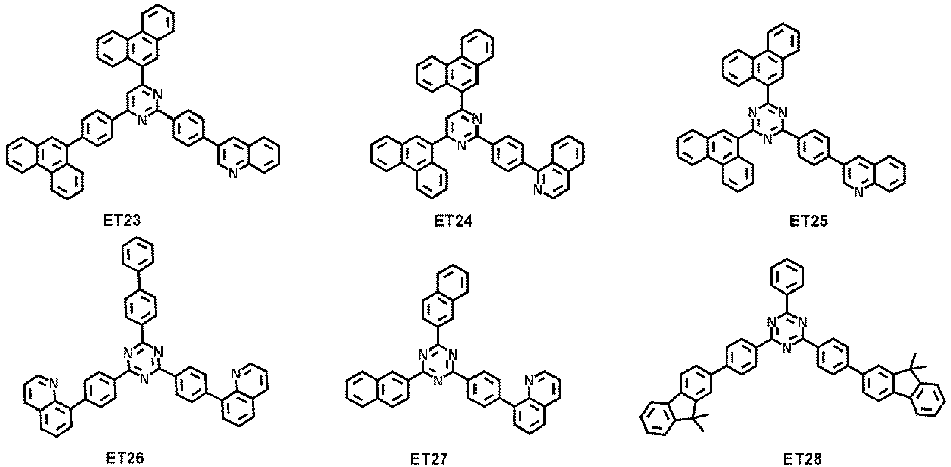

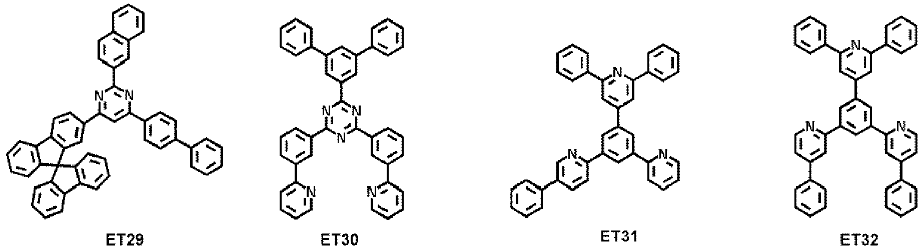

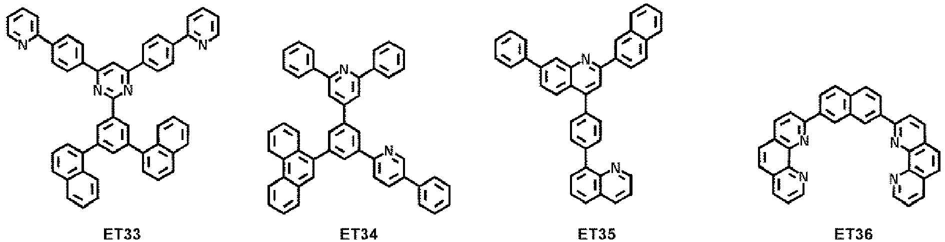

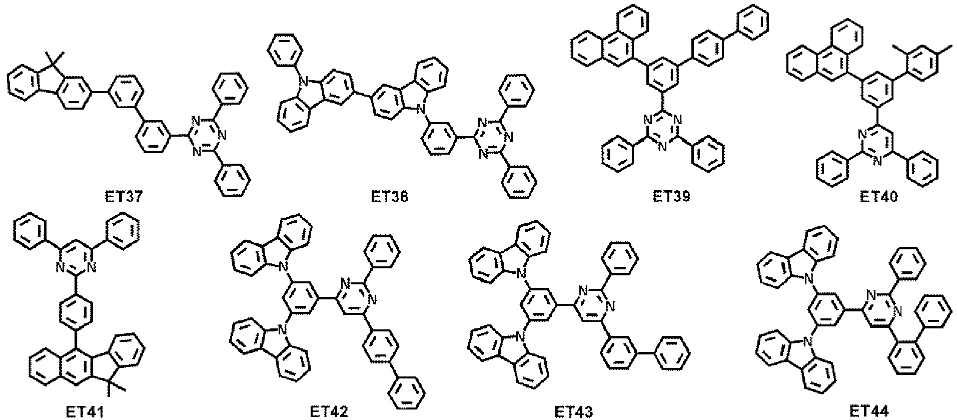

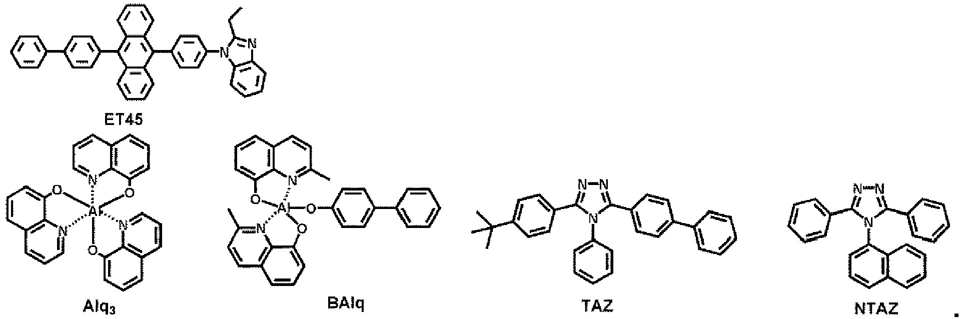

A thickness of the electron transport region may be from about 100 Å to about 5,000 Å, for example, about 160 Å to about 4,000 Å. When the electron transport region includes a buffer layer, a hole blocking layer, an electron control layer, an electron transport layer, or any combination thereof, a thickness of the buffer layer, the hole blocking layer, and/or the electron control layer may each independently be from about 20 Å to about 1,000 Å, for example, about 30 Å to about 300 Å, and a thickness of the electron transport layer may be from about 100 Å to about 1,000 Å, for example, about 150 Å to about 500 Å. When the thicknesses of the buffer layer, hole blocking layer, electron control layer, electron transport layer and/or electron transport region are within any of their respective ranges, satisfactory or suitable electron-transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or any combination thereof. A metal ion of the alkali metal complex may be a Li ion, a Na ion, a K ion, a Rb ion, and/or a Cs ion, and a metal ion of the alkaline earth metal complex may be a Be ion, a Mg ion, a Ca ion, a Sr ion, and/or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

In one or more embodiments, the metal-containing material may include a Li complex. The Li complex may include, for example, Compound ET-D1 (LiQ) and/or Compound ET-D2:

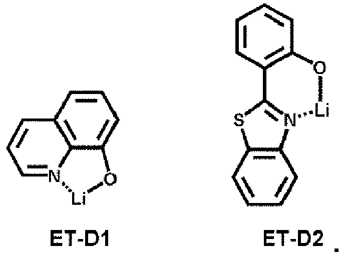

The electron transport region may include an electron injection layer that facilitates the injection of electrons from the second electrode 150. The electron injection layer may be in direct contact with the second electrode 150.

The electron injection layer may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may include oxides, halides (for example, fluorides, chlorides, bromides, and/or iodides), and/or tellurides of the alkali metal, the alkaline earth metal, and the rare earth metal, or any combination thereof.

The alkali metal-containing compound may include alkali metal oxides, such as Li₂O, Cs₂O, and/or K₂O; alkali metal halides, such as LiF, NaF, CsF, KF, Lil, Nal, Csl, and/or KI; or any combination thereof. The alkaline earth metal-containing compound may include an alkaline earth metal oxide, such as BaO, SrO, CaO, BaₓSr₁₋ₓO (x is a real number satisfying the condition of 0<x<1), BaₓCa₁₋ₓO (x is a real number satisfying the condition of 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In one or more embodiments, the rare earth metal-containing compound may include lanthanide metal telluride. Examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and Lu₂Te₃.

The alkali metal complex, the alkaline earth-metal complex, and the rare earth metal complex may include i) a corresponding one of metal ions of the alkali metal, the alkaline earth metal, or the rare earth metal, and ii), as a ligand bonded to the metal ion, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or any combination thereof.

The electron injection layer may include (e.g., may consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In one or more embodiments, the electron injection layer may further include an organic material (for example, a compound represented by Formula 601).

In one or more embodiments, the electron injection layer may include (e.g., may consist of) i) an alkali metal-containing compound (for example, an alkali metal halide), ii) a) an alkali metal-containing compound (for example, an alkali metal halide); and b) an alkali metal, an alkaline earth metal, a rare earth metal, or any combination thereof. In one or more embodiments, the electron injection layer may be a KI:Yb co-deposited layer, an Rbl:Yb co-deposited layer, and/or the like.

When the electron injection layer further includes an organic material, the alkali metal, the alkaline earth metal, the rare earth metal, the alkali metal-containing compound, the alkaline earth metal-containing compound, the rare earth metal-containing compound, the alkali metal complex, the alkaline earth-metal complex, the rare earth metal complex, or any combination thereof may be homogeneously or non-homogeneously dispersed in a matrix including the organic material.

A thickness of the electron injection layer may be in a range of about 1 Å to about 100 Å, and, for example, about 3 Å to about 90 Å. When the thickness of the electron injection layer is within any of the ranges described above, satisfactory or suitable electron injection characteristics may be obtained without a substantial increase in driving voltage.

### Second electrode 150

The second electrode 150 may be located on the interlayer 130 having the structure according to embodiments of the present disclosure. The second electrode 150 may be a cathode, which is an electron injection electrode, and as the material for the second electrode 150, a metal, an alloy, an electrically conductive compound, or any combination thereof, each having a low work function, may be utilized.

In one or more embodiments, the second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or a combination thereof. The second electrode 150 may be a transmissive electrode, a semi-transmissive electrode, or a reflective electrode.

The second electrode 150 may have a single-layered structure or a multi-layered structure including two or more layers.

### Capping layer

A first capping layer may be arranged outside the first electrode 110, and/or a second capping layer may be arranged outside the second electrode 150. In one or more embodiments, the light-emitting device 10 may have a structure in which the first capping layer, the first electrode 110, the interlayer 130, and the second electrode 150 are sequentially stacked in this stated order, a structure in which the first electrode 110, the interlayer 130, the second electrode 150, and the second capping layer are sequentially stacked in this stated order, or a structure in which the first capping layer, the first electrode 110, the interlayer 130, the second electrode 150, and the second capping layer are sequentially stacked in this stated order.

Light generated in an emission layer of the interlayer 130 of the light-emitting device 10 may be extracted toward the outside through the first electrode 110, which is a semi-transmissive electrode or a transmissive electrode, and the first capping layer, or light generated in an emission layer of the interlayer 130 of the light-emitting device 10 may be extracted toward the outside through the second electrode 150, which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the emission efficiency of the light-emitting device 10 may be improved.

Each of the first capping layer and second capping layer may include a material having a refractive index (at 589 nm) of 1.6 or more.

The first capping layer and the second capping layer may each independently be an organic capping layer including an organic material, an inorganic capping layer including an inorganic material, or an organic-inorganic composite capping layer including an organic material and an inorganic material.

At least one of the first capping layer or the second capping layer may each independently include one or more of carbocyclic compounds, heterocyclic compounds, amine group-containing compounds, porphyrin derivatives, phthalocyanine derivatives, naphthalocyanine derivatives, alkali metal complexes, alkaline earth metal complexes, or any combination thereof. The carbocyclic compound, the heterocyclic compound, and the amine group-containing compound may be optionally substituted with a substituent containing O, N, S, Se, Si, F, Cl, Br, I, or any combination thereof. In one or more embodiments, at least one of the first capping layer or the second capping layer may each independently include an amine group-containing compound.

In one or more embodiments, at least one of the first capping layer or the second capping layer may each independently include a compound represented by Formula 201, a compound represented by Formula 202, or any combination thereof.

In one or more embodiments, at least one of the first capping layer or the second capping layer may each independently include at least one (e.g., one) of Compounds HT28 to HT33, at least one (e.g., one) of Compounds CP1 to CP6, β-NPB, or any combination thereof:

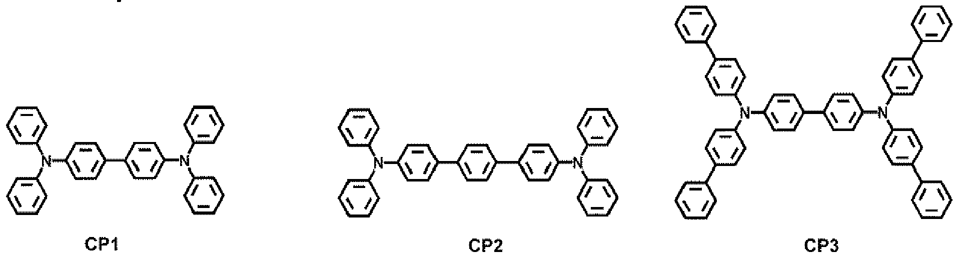

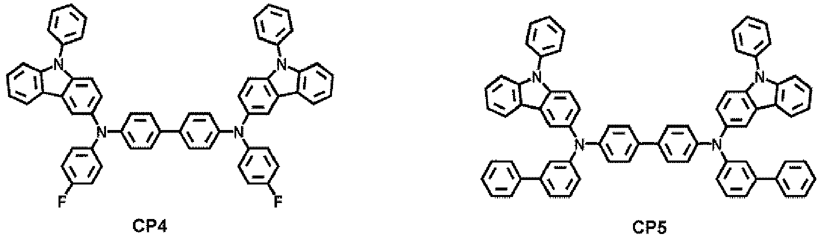

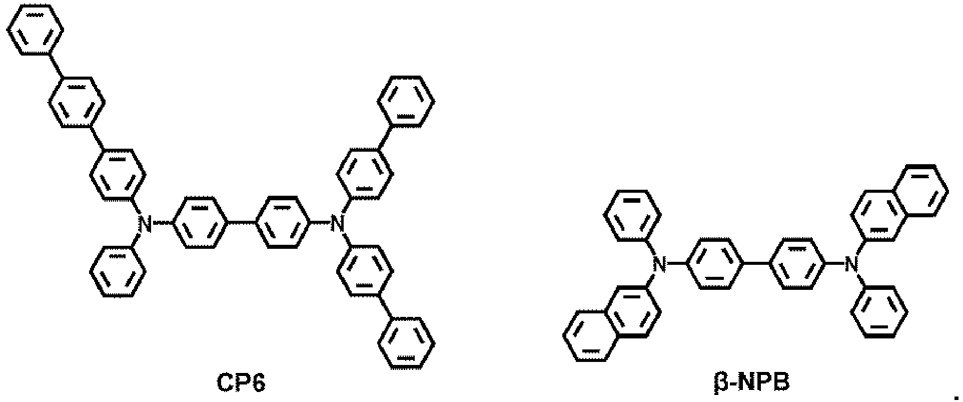

### [Film]

The heterocyclic compound represented by Formula 1 may be included in one or more suitable films. Accordingly, according to one or more embodiments, a film including the heterocyclic compound represented by Formula 1 may be provided. The film may be, for example, an optical member (or, a light-controlling member) (e.g., a color filter, a color-conversion member, a capping layer, a light extraction efficiency improvement layer, a selective light-absorbing layer, a polarizing layer, a quantum dot-containing layer, and/or the like), a light-blocking member (e.g., a light reflection layer or a light-absorbing layer), and/or a protection member (e.g., an insulating layer and/or a dielectric material layer).

### Electronic apparatus

The light-emitting device may be included in one or more suitable electronic apparatuses. In one or more embodiments, the electronic apparatus including the light-emitting device may be a light-emitting apparatus, an authentication apparatus, and/or the like.

The electronic apparatus (for example, light-emitting apparatus) may further include, in addition to the light-emitting device, i) a color filter, ii) a color conversion layer, or iii) a color filter and a color conversion layer. The color filter and/or the color conversion layer may be located in at least one traveling direction of light emitted from the light-emitting device. For example, the light emitted from the light-emitting device may be blue light or white light. The light-emitting device may be the same as described above. In one or more embodiments, the color conversion layer may include a quantum dot. The quantum dot may be, for example, the quantum dot as described herein.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining layer may be located among the subpixel areas to define each of the subpixel areas.

The color filter may further include a plurality of color filter areas and light-shielding patterns located among the color filter areas, and the color conversion layer may include a plurality of color conversion areas and light-shielding patterns located among the color conversion areas.

The color filter areas (or the color conversion areas) may include a first area emitting (e.g., configured to emit) first color light, a second area emitting (e.g., configured to emit) second color light, and/or a third area emitting (e.g., configured to emit) third color light, and the first color light, the second color light, and/or the third color light may have different maximum emission wavelengths from one another. In one or more embodiments, the first color light may be red light, the second color light may be green light, and the third color light may be blue light. In one or more embodiments, the color filter areas (or the color conversion areas) may include quantum dots. In one or more embodiments, the first area may include a red quantum dot, the second area may include a green quantum dot, and the third area may not include (e.g., may exclude) a quantum dot. The quantum dot is the same as described in the present specification. The first area, the second area, and/or the third area may each further include a scatterer.

In one or more embodiments, the light-emitting device may be to emit first light, the first area may be to absorb the first light to emit first first-color light, the second area may be to absorb the first light to emit second first-color light, and the third area may be to absorb the first light to emit third first-color light. In this regard, the first first-color light, the second first-color light, and the third first-color light may have different maximum emission wavelengths. For example, the first light may be blue light, the first first-color light may be red light, the second first-color light may be green light, and the third first-color light may be blue light.

The electronic apparatus may further include a thin-film transistor, in addition to the light-emitting device as described above. The thin-film transistor may include a source electrode, a drain electrode, and an activation layer, wherein one the source electrode or the drain electrode may be electrically connected to the first electrode or the second electrode of the light-emitting device.

The thin-film transistor may further include a gate electrode, a gate insulating film, etc.

The activation layer may include crystalline silicon, amorphous silicon, organic semiconductor, oxide semiconductor, and/or the like.

The electronic apparatus may further include a sealing portion for sealing the light-emitting device. The sealing portion and/or the color conversion layer may be located between the color filter and the light-emitting device. The sealing portion allows light from the light-emitting device to be extracted to the outside, while concurrently (e.g., simultaneously) preventing or reducing ambient air and/or moisture from penetrating into the light-emitting device. The sealing portion may be a sealing substrate including a transparent glass substrate and/or a plastic substrate. The sealing portion may be a thin-film encapsulation layer including at least one layer of an organic layer and/or an inorganic layer. When the sealing portion is a thin film encapsulation layer, the electronic apparatus may be flexible.

One or more suitable functional layers may be additionally located on the sealing portion, in addition to the color filter and/or the color conversion layer, according to the use of the electronic apparatus. The functional layers may include a touch screen layer, a polarizing layer, and/or the like. The touch screen layer may be a pressure-sensitive touch screen layer, a capacitive touch screen layer, and/or an infrared touch screen layer. The authentication apparatus may be, for example, a biometric authentication apparatus that authenticates an individual by utilizing biometric information of a living body (for example, fingertips, pupils, etc.).

The authentication apparatus may further include, in addition to the light-emitting device, a biometric information collector.

The electronic apparatus may be applied to one or more suitable displays, light sources, lighting apparatus, personal computers (for example, a mobile personal computer), mobile phones, digital cameras, electronic diaries, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, and/or endoscope displays), fish finders, one or more suitable measuring instruments, meters (for example, meters for a vehicle, an aircraft, and/or a vessel), projectors, and/or the like.

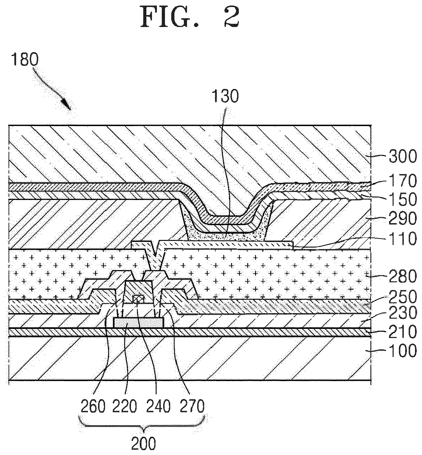

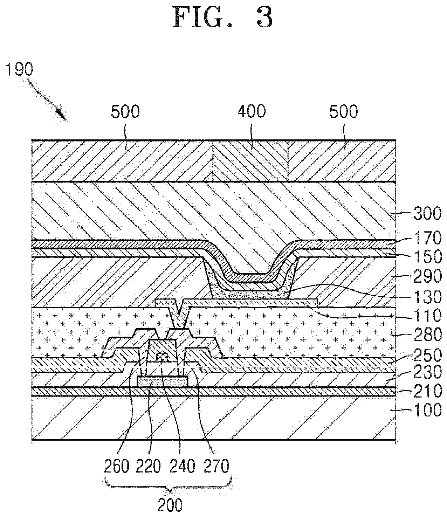

### Description of FIGS. 2 and 3

FIG. 2 is a cross-sectional view of an electronic apparatus according to one or more embodiments of the disclosure.

The electronic apparatus 180 of FIG. 2 may include a substrate 100, a thin-film transistor (TFT) 200, a light-emitting device, and an encapsulation portion 300 that seals the light-emitting device.

The substrate 100 may be a flexible substrate, a glass substrate, and/or a metal substrate. A buffer layer 210 may be formed on the substrate 100. The buffer layer 210 may prevent or reduce penetration of impurities through the substrate 100 and may provide a flat (or substantially flat) surface on the substrate 100.

A TFT 200 may be located on the buffer layer 210. The TFT 200 may include an activation layer 220, a gate electrode 240, a source electrode 260, and a drain electrode 270.

The activation layer 220 may include an inorganic semiconductor such as silicon and/or polysilicon, an organic semiconductor, and/or an oxide semiconductor, and may include a source region, a drain region and a channel region.

A gate insulating film 230 for insulating the activation layer 220 from the gate electrode 240 may be located on the activation layer 220, and the gate electrode 240 may be located on the gate insulating film 230.

An interlayer insulating film 250 is located on the gate electrode 240. The interlayer insulating film 250 may be placed between the gate electrode 240 and the source electrode 260 to insulate the gate electrode 240 from the source electrode 260 and between the gate electrode 240 and the drain electrode 270 to insulate the gate electrode 240 from the drain electrode 270.

The source electrode 260 and the drain electrode 270 may be located on the interlayer insulating film 250. The interlayer insulating film 250 and the gate insulating film 230 may be formed to expose the source region and the drain region of the activation layer 220, and the source electrode 260 and the drain electrode 270 may be in contact with the exposed portions of the source region and the drain region of the activation layer 220.

The TFT 200 may be electrically connected to a light-emitting device to drive the light-emitting device, and is covered by a passivation layer 280. The passivation layer 280 may include an inorganic insulating film, an organic insulating film, or a combination thereof. A light-emitting device is provided on the passivation layer 280. The light-emitting device may include a first electrode 110, an interlayer 130, and a second electrode 150.

The first electrode 110 may be formed on the passivation layer 280. In one or more embodiments, the passivation layer 280 does not completely cover the drain electrode 270 and exposes a portion of the drain electrode 270, and the first electrode 110 is connected to the exposed portion of the drain electrode 270.

A pixel-defining layer 290 containing an insulating material may be located on the first electrode 110. The pixel-defining layer 290 exposes a region of the first electrode 110, and an interlayer 130 may be formed in the exposed region of the first electrode 110. The pixel-defining layer 290 may be a polyimide and/or polyacrylic organic film. In one or more embodiments, at least some layers of the interlayer 130 may extend beyond the upper portion of the pixel-defining layer 290 to be located in the form of a common layer.

The second electrode 150 may be located on the interlayer 130, and a capping layer 170 may be additionally formed on the second electrode 150. The capping layer 170 may be formed to cover the second electrode 150.

The encapsulation portion 300 may be located on the capping layer 170. The encapsulation portion 300 may be located on a light-emitting device to protect the light-emitting device from moisture and/or oxygen. The encapsulation portion 300 may include: an inorganic film including silicon nitride (SiNx), silicon oxide (SiOx), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or a combination thereof; or a combination of the inorganic film and the organic film.

FIG. 3 is a cross-sectional view of a light-emitting apparatus according to one or more other embodiments of the disclosure.

The electronic apparatus 190 of FIG. 3 is the same as the electronic apparatus 180 of FIG. 2, except that a light-shielding pattern 500 and a functional region 400 are additionally arranged on the encapsulation portion 300. The functional region 400 may be a combination of i) a color filter area, ii) a color conversion area, or iii) a combination of the color filter area and the color conversion area. In one or more embodiments, a light-emitting device included in the electronic apparatus 190 of FIG. 3 may be a tandem light-emitting device.

### Manufacture method

Respective layers included in the hole transport region, the emission layer, and respective layers included in the electron transport region may be formed in a certain region by utilizing one or more suitable methods selected from vacuum deposition, spin coating, casting, Langmuir-Blodgett (LB) deposition, ink-jet printing, laser-printing, and laser-induced thermal imaging.

When layers constituting the hole transport region, the emission layer, and layers constituting the electron transport region are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### Definition of terms

The term "C₃-C₆₀ carbocyclic group" as used herein refers to a cyclic group consisting of carbon atoms only as ring-forming atoms and having three to sixty carbon atoms, and the term "C₁-C₆₀ heterocyclic group" as used herein refers to a cyclic group that has one to sixty carbon atoms and further has, in addition to carbon, at least one heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. In one or more embodiments, the C₁-C₆₀ heterocyclic group has 3 to 61 ring-forming atoms.

The term "cyclic group" as used herein may include the C₃-C₆₀ carbocyclic group and the C₁-C₆₀ heterocyclic group.

The term "π electron-rich C₃-C₆₀ cyclic group" as used herein refers to a cyclic group that has three to sixty carbon atoms and does not include *-N=*' as a ring-forming moiety, and the term "π electron-deficient nitrogen-containing C₁-C₆₀ cyclic group" as used herein refers to a heterocyclic group that has one to sixty carbon atoms and includes *-N=*' as a ring-forming moiety.

In one or more embodiments,
the C₃-C₆₀ carbocyclic group may be i) a group T1 or ii) a condensed cyclic group in which two or more groups T1 are condensed with each other (for example, the C₃-C₆₀ carbocyclic group may be a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, and/or an indenoanthracene group),
the C₁-C₆₀ heterocyclic group may be i) a group T2, ii) a condensed cyclic group in which two or more groups T2 are condensed with each other, or iii) a condensed cyclic group in which at least one group T2 and at least one group T1 are condensed with each other (for example, the C₁-C₆₀ heterocyclic group may be a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) a group T1, ii) a condensed cyclic group in which two or more groups T1 are condensed with each other, iii) a group T3, iv) a condensed cyclic group in which two or more groups T3 are condensed with each other, or v) a condensed cyclic group in which at least one group T3 and at least one group T1 are condensed with each other (for example, the π electron-rich C₃-C₆₀ cyclic group may be the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
the π electron-deficient nitrogen-containing C₁-C₆₀ cyclic group may be i) a group T4, ii) a condensed cyclic group in which two or more group T4 are condensed with each other, iii) a condensed cyclic group in which at least one group T4 and at least one group T1 are condensed with each other, iv) a condensed cyclic group in which at least one group T4 and at least one group T3 are condensed with each other, or v) a condensed cyclic group in which at least one group T4, at least one group T1, and at least one group T3 are condensed with one another (for example, e π electron-deficient nitrogen-containing C₁-C₆₀ cyclic group may be a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, and/or a benzene group,
the group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, and/or a dihydropyridazine group,
the group T3 may be a furan group, a thiophene group, a 1H-pyrrole group, a silole group, and/or a borole group, and
the group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, and/or a tetrazine group.

The term "cyclic group", "C₃-C₆₀ carbocyclic group", "C₁-C₆₀ heterocyclic group", "π electron-rich C₃-C₆₀ cyclic group", and/or "π electron-deficient nitrogen-containing C₁-C₆₀ cyclic group" as used herein may refer to a group condensed to (e.g., included in) any cyclic group or a polyvalent group (for example, a divalent group, a trivalent group, a tetravalent group, etc.), depending on the structure of a formula in connection with which the terms are utilized. In one or more embodiments, "a benzene group" may refer to a benzene ring, a phenyl group, a phenylene group, and/or the like, which may be easily understood by one of ordinary skill in the art according to the structure of a formula including the "benzene group."

In one or more embodiments, examples of a monovalent C₃-C₆₀ carbocyclic group and a monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group; and examples of a divalent C₃-C₆₀ carbocyclic group and a divalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as utilized herein refers to a linear or branched aliphatic hydrocarbon monovalent group that has one to sixty carbon atoms, and examples thereof may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as used herein refers to a divalent group having the same structure as the C₁-C₆₀ alkyl group.

The term "C₂-C₆₀ alkenyl group" as used herein refers to a monovalent hydrocarbon group having at least one carbon-carbon double bond in the middle and/or at the terminus of the C₂-C₆₀ alkyl group, and examples thereof may include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a monovalent hydrocarbon group having at least one carbon-carbon triple bond in the middle and/or at the terminus of the C₂-C₆₀ alkyl group, and examples thereof may include an ethynyl group and a propynyl group. The term "C₂-C₆₀ alkynylene group" as used herein refers to a divalent group having the same structure as the C₂-C₆₀ alkynyl group.

The term "C₁-C₆₀ alkoxy group" as used herein refers to a monovalent group represented by -OA₁₀₁ (wherein A₁₀₁ is the C₁-C₆₀ alkyl group), and examples thereof may include a methoxy group, an ethoxy group, and an isopropyloxy group.

The term "C₃-C₁₀ cycloalkyl group" as used herein refers to a monovalent saturated hydrocarbon cyclic group having 3 to 10 carbon atoms, and examples thereof may include a cyclopropyl group, a cyclobutyl group, a cyclopentyl group, a cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent cyclic group that further includes, in addition to carbon atoms, at least one heteroatom as a ring-forming atom, and has 1 to 10 carbon atoms, and examples thereof may include a 1,2,3,4-oxatriazolidinyl group, a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent cyclic group that has three to ten carbon atoms and at least one carbon-carbon double bond in the ring thereof and no aromaticity in its molecular structure when considered as a whole, and examples thereof may include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group that has, in addition to carbon atoms, at least one heteroatom as a ring-forming atom, 1 to 10 carbon atoms, and at least one carbon-carbon double bond in the cyclic structure thereof. Examples of the C₁-C₁₀ heterocycloalkenyl group may include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having six to sixty carbon atoms. Examples of the C₆-C₆₀ aryl group may include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. The term "C₆-C₆₀ arylene group" as utilized herein refers to a divalent group having the same structure as the C₆-C₆₀ aryl group. When the C₆-C₆₀ aryl group and the C₆-C₆₀ arylene group each independently include two or more rings, the respective rings may be condensed with each other.

The term "C₁-C₆₀ heteroaryl group" as used herein refers to a monovalent group having a heterocyclic aromatic system that has, in addition to carbon atoms, at least one heteroatom as a ring-forming atom, and 1 to 60 carbon atoms. The term "C₁-C₆₀ heteroarylene group" as used herein refers to a divalent group having the same structure as the C₁-C₆₀ heteroaryl group. Examples of the C₁-C₆₀ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each independently include two or more rings, the respective rings may be condensed with each other.

The term "monovalent non-aromatic condensed polycyclic group" as used herein refers to a monovalent group having two or more rings condensed to each other, only carbon atoms (for example, having 8 to 60 carbon atoms) as ring-forming atoms, and non-aromaticity in its molecular structure when considered as a whole. Examples of the monovalent non-aromatic condensed polycyclic group may include an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group having two or more rings condensed to each other, at least one heteroatom other than carbon atoms (for example, having 1 to 60 carbon atoms), as a ring-forming atom, and non-aromaticity in its molecular structure when considered as a whole. Examples of the monovalent non-aromatic condensed heteropolycyclic group may include a pyrrolyl group, a thiophenyl group, a furanyl group, an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as used herein refers to a divalent group having the same structure as a monovalent non-aromatic condensed heteropolycyclic group.

The term "C₆-C₆₀ aryloxy group" as used herein refers to -OA₁₀₂ (wherein A₁₀₂ is the C₆-C₆₀ aryl group), and the term "C₆-C₆₀ arylthio group" as used herein refers to -SA₁₀₃ (wherein A₁₀₃ is the C₆-C₆₀ aryl group).

The term "C₇₋C₆₀ aryl alkyl group" as used herein refers to -A₁₀₄A₁₀₅ (where A₁₀₄ may be a C₁-C₅₄ alkylene group, and A₁₀₆ may be a C₆-C₅₉ aryl group), and the term "C₂-C₆₀ heteroaryl alkyl group" as used herein refers to -A₁₀₆A₁₀₇(where A₁₀₆ may be a C₁-C₆₀ alkylene group, and A₁₀₇ may be a C₁-C₅₉ heteroaryl group).

R₁₀ₐ as used herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇₋C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q₁₃, Q₂₁ to Q₂₃, and Q₃₁ to Q₃₃ as used herein may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₇-C₆₀ aryl alkyl group, or a C₂-C₆₀ heteroaryl alkyl group, each unsubstituted or substituted with deuterium, -F, a cyano group, a C₁-C₆₀ alkyl group, a C₁-C₆₀ alkoxy group, a phenyl group, a biphenyl group, or any combination thereof.

The term "hetero atom" as used herein refers to any atom other than a carbon atom. Examples of the heteroatom may include O, S, N, P, Si, B, Ge, Se, or any combination thereof.

The term "third-row transition metal" as used herein includes hafnium (Hf), tantalum (Ta), tungsten (W), rhenium (Re), osmium (Os), iridium (Ir), platinum (Pt), gold (Au), and/or the like.

"Ph" as used herein refers to a phenyl group, "Me" as used herein refers to a methyl group, "Et" as used herein refers to an ethyl group, "tert-Bu" or "Bu^{t}" as used herein refers to a tert-butyl group, and "OMe" as used herein refers to a methoxy group.

The term "biphenyl group" as used herein refers to "a phenyl group substituted with a phenyl group." For example, the "biphenyl group" may be a substituted phenyl group having a C₆-C₆₀ aryl group as a substituent.

The term "terphenyl group" as used herein refers to "a phenyl group substituted with a biphenyl group". The "terphenyl group" may be a substituted phenyl group having, as a substituent, a C₆-C₆₀ aryl group substituted with a C₆-C₆₀ aryl group.

In the present specification, * and *', unless defined otherwise, each refer to a binding site to a neighboring atom in a corresponding formula or moiety.

Hereinafter, compounds according to embodiments and light-emitting devices according to embodiments will be described in more detail with reference to the following synthesis examples and examples. The wording "B was used instead of A" used in describing Synthesis Examples means that an amount of B used was identical to an amount of A used in terms of molar equivalents.

### Examples

### Manufacture of light-emitting device

### Example 1

ITO 300Å / Ag 50Å / ITO 300Å (anode) was cut to a size of 50 mm x 50 mm x 0.7 mm, sonicated by using isopropyl alcohol and pure water each for 15 minutes, and then cleaned by irradiation of ultraviolet rays and exposure of ozone thereto for 30 minutes, and the glass substrate was loaded into a vacuum deposition apparatus.

HAT-CN was vacuum-deposited on the substrate to form a hole injection layer having a thickness of 50 Å. Subsequently, NPB as a hole transporting compound was vacuum-deposited on the hole injection layer to form a hole transport layer having a thickness of 600 Å. Next, Compound 1 was vacuum-deposited on the hole transport layer to form an electron blocking layer having a thickness of 50 Å.

Blue Host_1 as a first host and Blue Dopant as a dopant were co-deposited on the electron blocking layer at a weight ratio of 99:1 to form a first emission layer having a thickness of 100 Å, and Blue Host_2 as a second host and Blue Dopant as a dopant were co-deposited on the first emission layer at a weight ratio of 99:1 to form a second emission layer having a thickness of 100 Å.

Next, T2T was deposited thereon to form a hole blocking layer having a thickness of 50 Å, and then TPM-TAZ and Liq were deposited thereon at a weight ratio of 5:5 to form an electron transport layer having a thickness of 200 Å.

Next, BCP and Li were co-deposited thereon at a weight ratio of 99:1 to form an n-type charge generation layer having a thickness of 50 Å, and HAT-CN was deposited on the n-type charge generation layer to form a p-type charge generation layer having a thickness of 50 Å.

NPB was deposited on the p-type charge generation layer to form a hole transport layer having a thickness of 600 Å, and Compound 1 was vacuum-deposited on the hole transport layer to form an electron blocking layer having a thickness of 50 Å.

Blue Host_1 as a first host and Blue Dopant as a dopant were co-deposited on the electron blocking layer at a weight ratio of 99:1 to form a first emission layer having a thickness of 100 Å, and Blue Host_2 as a second host and Blue Dopant as a dopant were co-deposited on the first emission layer at a weight ratio of 99:1 to form a second emission layer having a thickness of 100 Å.

Subsequently, T2T was deposited thereon to form a hole blocking layer having a thickness of 50 Å, and then TPM-TAZ and Liq were deposited thereon at a weight ratio of 5:5 to form an electron transport layer having a thickness of 300 Å.

Next, BCP and Li were co-deposited thereon at a weight ratio of 99:1 to form an n-type charge generation layer having a thickness of 50 Å, and HAT-CN was deposited on the n-type charge generation layer to form a p-type charge generation layer having a thickness of 50 Å.

NPB was deposited on the p-type charge generation layer to form a hole transport layer having a thickness of 600 Å, and Compound 1 was vacuum-deposited on the hole transport layer to form an electron blocking layer having a thickness of 50 Å.

Blue Host_1 as a first host and Blue Dopant as a dopant were co-deposited on the electron blocking layer at a weight ratio of 99:1 to form a first emission layer having a thickness of 100 Å, and Blue Host_2 as a second host and Blue Dopant as a dopant were co-deposited on the first emission layer at a weight ratio of 99:1 to form a second emission layer having a thickness of 100 Å.

Subsequently, T2T was deposited thereon to form a hole blocking layer having a thickness of 50 Å, and then TPM-TAZ and Liq were deposited thereon at a weight ratio of 5:5 to form an electron transport layer having a thickness of 300 Å.

Next, Yb was deposited to a thickness of 10 Å, Ag and Mg were co-deposited thereon at a weight ratio of 9:1 to form a cathode having a thickness of 100 Å, and CPL was deposited thereon to form a capping layer having a thickness of 600 Å, thereby completing manufacture of a tandem-type or kind light-emitting device.

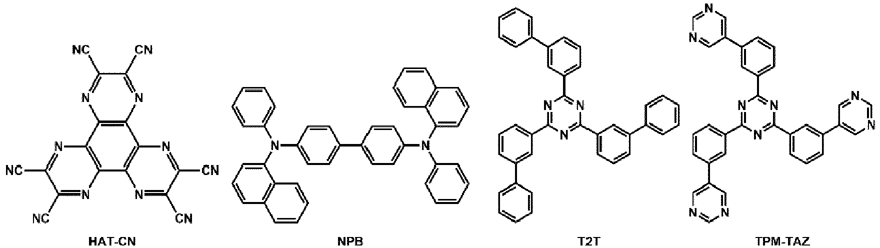

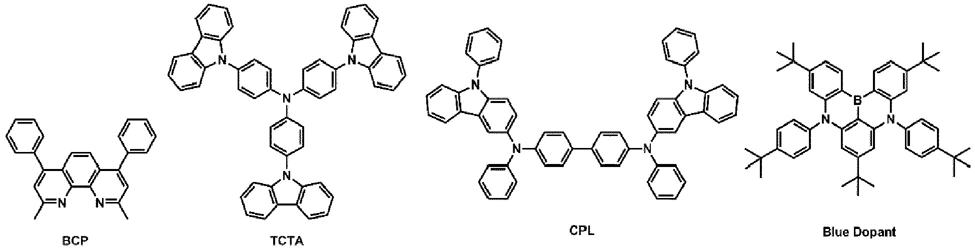

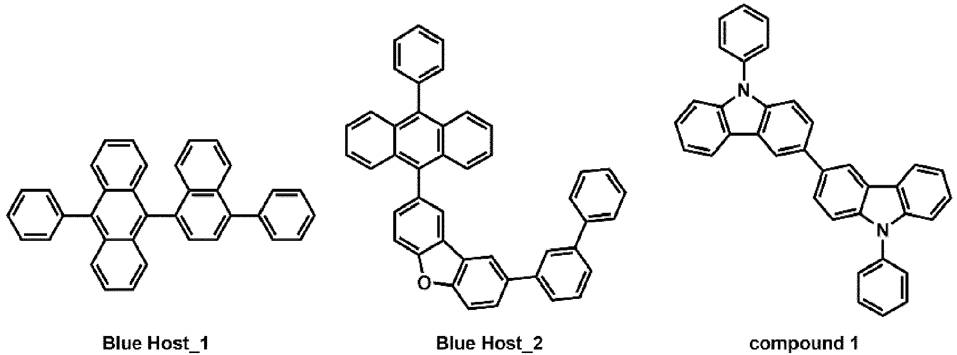

### Comparative Example 1

A light-emitting device was manufactured in substantially the same manner as in Example 1, except that TCTA was utilized instead of Compound 1.

### Example 2

ITO 300Å / Ag 50Å / ITO 300Å (anode) was cut to a size of 50 mm x 50 mm x 0.7 mm, sonicated by using isopropyl alcohol and pure water each for 15 minutes, and then cleaned by irradiation of ultraviolet rays and exposure of ozone thereto for 30 minutes, and the glass substrate was loaded into a vacuum deposition apparatus.

HATCN was vacuum-deposited on the substrate to form a hole injection layer having a thickness of 50 Å. Subsequently, NPB as a hole transporting compound was vacuum-deposited on the hole injection layer to form a hole transport layer having a thickness of 600 Å. Next, TCTA was vacuum-deposited on the hole transport layer to form an electron blocking layer having a thickness of 50 Å.

Blue Host_1 as a first host and Blue Dopant as a dopant were co-deposited on the electron blocking layer at a weight ratio of 99:1 to form a first emission layer having a thickness of 100 Å, and Blue Host_2 as a second host and Blue Dopant as a dopant were co-deposited on the first emission layer at a weight ratio of 99:1 to form a second emission layer having a thickness of 100 Å.

Next, T2T was deposited thereon to form a hole blocking layer having a thickness of 50 Å, and then TPM-TAZ and Liq were deposited thereon at a weight ratio of 5:5 to form an electron transport layer having a thickness of 200 Å.

Next, BCP and Li were co-deposited thereon at a weight ratio of 99:1 to form an n-type charge generation layer having a thickness of 50 Å, and HAT-CN was deposited on the n-type charge generation layer to form a p-type charge generation layer having a thickness of 50 Å.

NPB was deposited on the p-type charge generation layer to form a hole transport layer having a thickness of 600 Å, and TCTA was vacuum-deposited on the hole transport layer to form an electron blocking layer having a thickness of 50 Å.

Blue Host_1 as a first host and Blue Dopant as a dopant were co-deposited on the electron blocking layer at a weight ratio of 99:1 to form a first emission layer having a thickness of 100 Å, and Blue Host_2 as a second host and Blue Dopant as a dopant were co-deposited on the first emission layer at a weight ratio of 99:1 to form a second emission layer having a thickness of 100 Å.

Subsequently, T2T was deposited thereon to form a hole blocking layer having a thickness of 50 Å, and then TPM-TAZ and Liq were deposited thereon at a weight ratio of 5:5 to form an electron transport layer having a thickness of 300 Å.

Next, BCP and Li were co-deposited thereon at a weight ratio of 99:1 to form an n-type charge generation layer having a thickness of 50 Å, and HAT-CN was deposited on the n-type charge generation layer to form a p-type charge generation layer having a thickness of 50 Å.

NPB was deposited on the p-type charge generation layer to form a hole transport layer having a thickness of 600 Å, and Compound 1 was vacuum-deposited on the hole transport layer to form an electron blocking layer having a thickness of 50 Å.

Blue Host_1 as a first host and Blue Dopant as a dopant were co-deposited on the electron blocking layer at a weight ratio of 99:1 to form a first emission layer having a thickness of 100 Å, and Blue Host_2 as a second host and Blue Dopant as a dopant were co-deposited on the first emission layer at a weight ratio of 99:1 to form a second emission layer having a thickness of 100 Å.

Subsequently, T2T was deposited thereon to form a hole blocking layer having a thickness of 50 Å, and then TPM-TAZ and Liq were deposited thereon at a weight ratio of 5:5 to form an electron transport layer having a thickness of 300 Å.

Next, BCP and Li were co-deposited thereon at a weight ratio of 99:1 to form an n-type charge generation layer having a thickness of 50 Å, and HAT-CN was deposited on the n-type charge generation layer to form a p-type charge generation layer having a thickness of 50 Å.

NPB was deposited on the p-type charge generation layer to form a hole transport layer having a thickness of 600 Å.

A host including Green Host_1 and Green Host_2 (a weight ratio of 1:1) and a dopant including Green Dopant were co-deposited on the electron blocking layer at a weight ratio of 99:1 to form an emission layer having a thickness of 200 Å.

Next, TPM-TAZ and Liq were deposited thereon at a weight ratio of 5:5 to form an electron transport layer having a thickness of 300 Å.

Next, Yb was deposited to a thickness of 10 Å, Ag and Mg were co-deposited thereon at a weight ratio of 9:1 to form a cathode having a thickness of 100 Å, and CPL was deposited thereon to form a capping layer having a thickness of 700 Å, thereby completing manufacture of a tandem-type or kind light-emitting device.

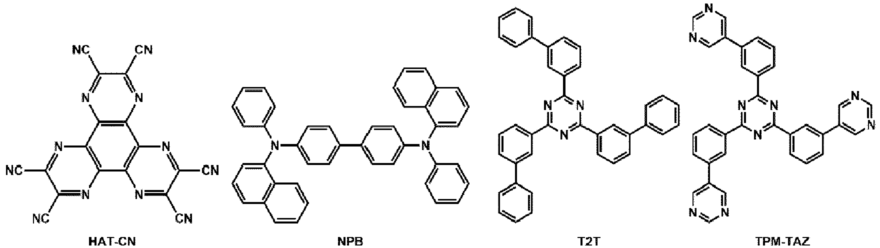

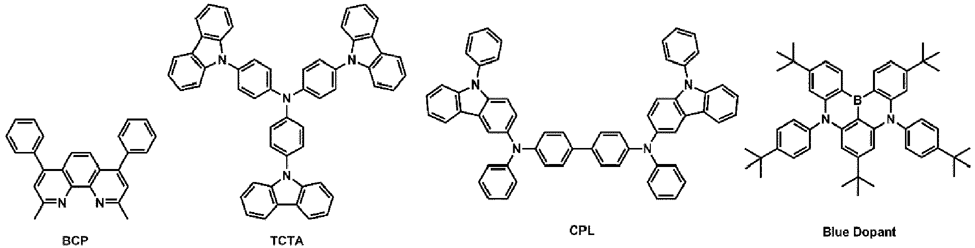

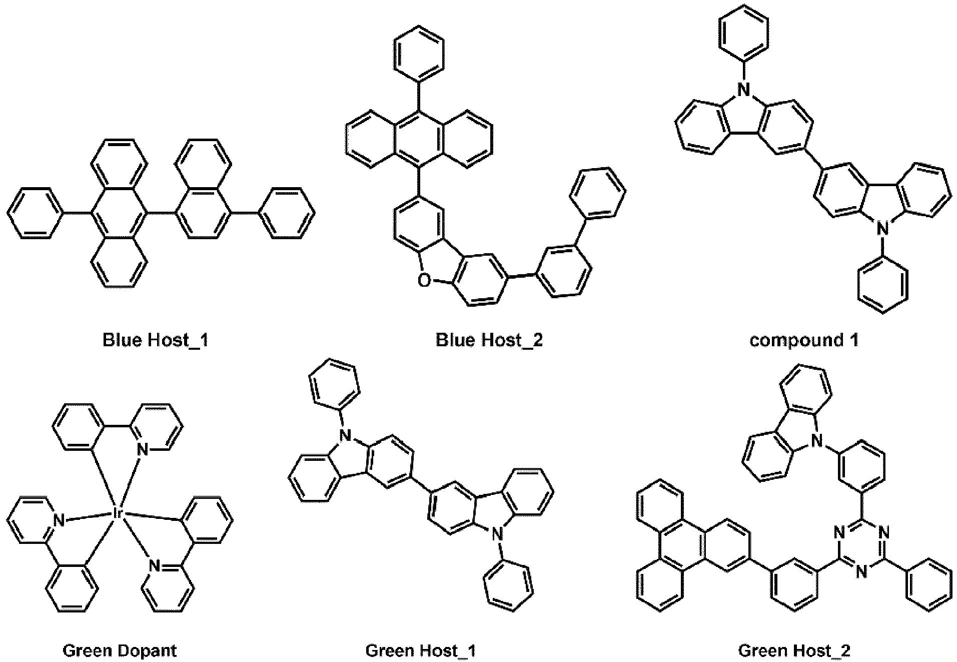

### Comparative Example 2

A light-emitting device was manufactured in substantially the same manner as in Example 2, except that TCTA was utilized instead of Compound 1.

### Evaluation Example 1

The driving voltage at 1,000 cd/m², luminescence efficiency (Cd/A), lifespan (T97), and luminance of the light-emitting devices manufactured in Examples 1 and 2 and Comparative Examples 1 and 2 were measured by utilizing the Keithley SMU 236, the luminance meter PR650, and transient EL measurement, and results thereof are shown in Table 1. The results of Example 1 were measured as relative values, based on Comparative Example 1, and the results of Example 2 were measured as relative values, based on Comparative Example 2. The lifespan (T₉₇) is a measure of the time (hr) taken when the luminance reaches 97% of the initial luminance.

### Evaluation Example 2: Hole mobility

HAT-CN, a compound that is subject to measure hole mobility, HAT-CN, Ag, and AgMg were sequentially stacked on an ITO electrode (80nm) to thereby manufacture a hole only device(HOD) having a structure of ITO (80nm) / HAT-CN (5nm)/ compound that is subject to measure hole mobility (50nm) / HAT-CN (5nm) / Ag (5nm)/AgMg(100nm). Hole mobility of Compound 1 and TCTA were evaluated by applying the Gurney-Mott theory to the HOD.

**Table 1**

| Example | Electron blocking layer | Hole mobility (cm²/V·s) | Driving voltage (V) | Luminesc ence Efficiency (Cd/A) | Lifespan (hr, T97@1, 000nit) | Lumina nce (nit) |
|---|---|---|---|---|---|---|
| Example1 | Compound 1 | 0.05 | 95 | 100 | 100 | 1500 |
| Comparative Example 1 | TCTA | 0.003 | 100 | 100 | 100 | 1500 |
| Example 2 | Compound 1 | 0.05 | 96 | 101 | 100 | 1500 |
| Comparative Example 2 | TCTA | 0.003 | 100 | 100 | 100 | 1500 |

From the results shown in Table 1, it was confirmed that the driving voltages of the light-emitting devices of Examples 1 and 2 were reduced, as compared to that of the light-emitting devices of Comparative Examples 1 and 2.

Without being bound by any particular theory, it is believed that because the light-emitting device includes an electron blocking layer including the heterocyclic compound represented by Formula 1, the hole mobility of the light-emitting device may be improved. Therefore, the driving voltage of the light-emitting device including the electron blocking layer is reduced, and thus, the luminescence efficiency of the light-emitting device may be further improved.

The electronic apparatus and/or any other relevant devices or components according to embodiments of the present invention described herein may be implemented utilizing any suitable hardware, firmware (e.g. an application-specific integrated circuit), software, or a combination of software, firmware, and hardware. For example, the various components of the apparatus may be formed on one integrated circuit (IC) chip or on separate IC chips. Further, the various components of the apparatus may be implemented on a flexible printed circuit film, a tape carrier package (TCP), a printed circuit board (PCB), or formed on one substrate. Further, the various components of the apparatus may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the exemplary embodiments of the present invention.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the drawings, it will be understood by those of ordinary skill in the art that one or more suitable changes in form and details may be made therein without departing from the scope as defined by the following claims.

## Claims

1. A light-emitting device comprising:
a first electrode;
a second electrode facing the first electrode;
an interlayer between the first electrode and the second electrode, the interlayer comprising an emission layer; and
a hole transport region between the first electrode and the interlayer,
wherein the hole transport region comprises an electron blocking layer, and
the electron blocking layer comprises a heterocyclic compound represented by Formula 1: 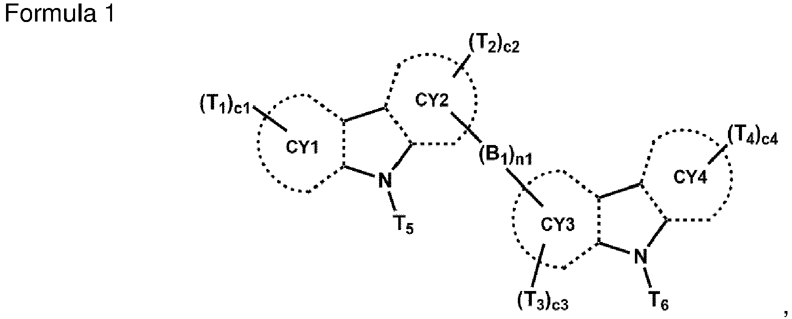
wherein, in Formula 1,
ring CY1 to ring CY4 are each independently a C₃-C₆₀ carbocyclic group or a C₁-C₆₀ heterocyclic group,
T₁ is *-(L₁)a₁-(R₁)_{b1},
T₂ is *-(L₂)a₂-(R₂)b₂,
T₃ is *-(L₃)ₐ₃-(R₃)_{b3},
T₄ is *-(L₄)ₐ₄-(R₄)_{b4},
T₅ is *-(L₅)ₐ₅-(R₅)_{b5},
T₆ is *-(L₆)ₐ₆-(R₆)_{b6},
* indicates a binding site to a neighboring atom,
c1 to c4 are each independently an integer from 0 to 10,
B₁ and L₁ to L₆ are each independently a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
n1 and a1 to a6 are each independently an integer from 0 to 3,
R₁ to R₆ are each independently hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, a C₇-C₆₀ aryl alkyl group that is unsubstituted or substituted with at least one R₁₀ₐ, a C₂-C₆₀ heteroaryl alkyl group that is unsubstituted or substituted with at least one R₁₀ₐ, -Si(Q₁)(Q₂)(Q₃), -N(Q₁)(Q₂), -B(Q₁)(Q₂), - C(=O)(Q₁), -S(=O)₂(Q₁), or -P(=O)(Q₁)(Q₂),
b1 to b6 are each independently an integer from 0 to 10,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇₋C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇₋C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇₋C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q31)(Q32)(Q33), -N(Q31)(Q32), -B(Q31)(Q32), -C(=O)(Q31), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ are each independently:
hydrogen; deuterium; -F; -Cl; -Br; -I; a hydroxyl group; a cyano group; a nitro group; or
a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₇-C₆₀ aryl alkyl group, or a C₂-C₆₀ heteroaryl alkyl group, each unsubstituted or substituted with deuterium, -F, a cyano group, a C₁-C₆₀ alkyl group, a C₁-C₆₀ alkoxy group, a phenyl group, a biphenyl group, a C₁-C₆₀ heterocyclic group, or any combination thereof.

2. The light-emitting device of claim 1, wherein ring CY1 to ring CY4 are each independently a benzene group, a naphthalene group, a phenanthrene group, a benzoquinoline group, a benzoisoquinoline group, a phenanthridine group, a benzimidazole group, a benzoxazole group, a carbazole group, or a dibenzofuran group.

3. The light-emitting device of claim 1 or claim 2, wherein ring CY1 to ring CY4 are each a benzene group.

4. The light-emitting device of any one of claims 1 to 3, wherein the heterocyclic compound is represented by one of Formulae 1-1 to 1-4: 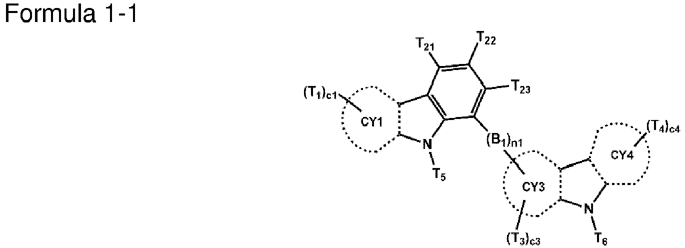 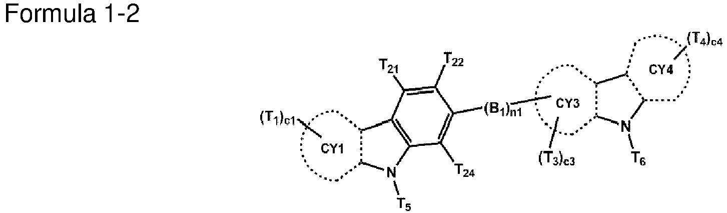 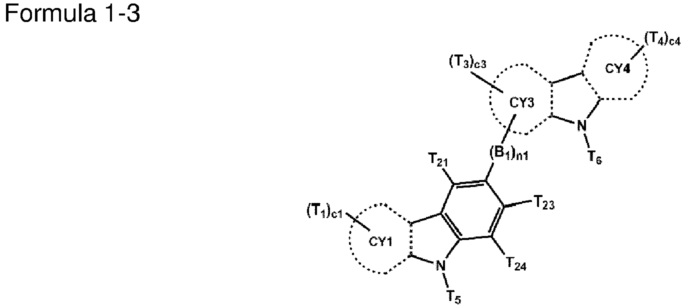 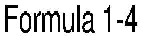 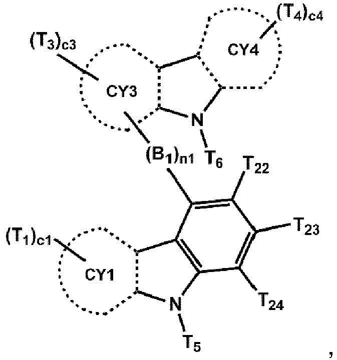
wherein, in Formulae 1-1 to 1-4,
CY1, CY3, CY4, T₁, T₃, T₄, T₅, T₆, c1, c3, c4, B₁, and n1 are each independently the same as described in Formula 1,
T₂₁ is *-(L₂₁)ₐ₂₁-(R₂₁)_{b21},
T₂₂ is *-(L₂₂)ₐ₂₂-(R₂₂)_{b22},
T₂₃ is *-(L₂₃)ₐ₂₃-(R₂₃)_{b23},
T₂₄ is *-(L₂₄)ₐ₂₄-(R₂₄)_{b24},
* indicates a binding site to a neighboring atom,
L₂₁ to L₂₄ are each independently the same as described in connection with L₂ in claim 1,
a21 to a24 are each independently the same as described in connection with a2 in claim 1,
R₂₁ to R₂₄ are each independently the same as described in connection with R₂ in claim 1, and
b21 to b24 are each independently the same as described in connection with b2 in claim 1.

5. The light-emitting device of any one of claims 1 to 4, wherein B₁ is:
a single bond; or
a benzene group that is unsubstituted or substituted with at least one R₁₀ₐ, a naphthalene group that is unsubstituted or substituted with at least one R₁₀ₐ, an anthracene group that is unsubstituted or substituted with at least one R₁₀ₐ, a phenanthrene group that is unsubstituted or substituted with at least one R₁₀ₐ, a benzoquinoline group that is unsubstituted or substituted with at least one R₁₀ₐ, a benzoisoquinoline group that is unsubstituted or substituted with at least one R₁₀ₐ, a phenanthridine group that is unsubstituted or substituted with at least one R₁₀ₐ, a benzimidazole group that is unsubstituted or substituted with at least one R₁₀ₐ, a benzoxazole group that is unsubstituted or substituted with at least one R₁₀ₐ, a carbazole group that is unsubstituted or substituted with at least one R₁₀ₐ, a dibenzofuran group that is unsubstituted or substituted with at least one R₁₀ₐ, a fluorene group that is unsubstituted or substituted with at least one R₁₀ₐ, a dibenzothiophene group that is unsubstituted or substituted with at least one R₁₀ₐ, or a dibenzosilole group that is unsubstituted or substituted with at least one R₁₀ₐ.

6. The light-emitting device of any one of claims 1 to 5, wherein L₁ to L₆ are each independently:
a single bond; or
a phenylene group, a naphthylene group, a phenanthrenylene group, a carbazolylene group, a dibenzofuranylene group, a dibenzothiophenylene group, a dibenzosilolylene group, a benzoquinolinylene group, a benzoisoquinolinylene group, a phenanthridinylene group, a benzimidazolylene group, or a benzoxazolylene group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a phenanthrenyl group, a carbazolyl group, a dibenzofuranyl group, a dibenzothiophenyl group, a dibenzosilolyl group, a benzoquinolinyl group, a benzoisoquinolinyl group, a phenanthridinyl group, a benzoimidazolyl group, a benzoxazolyl group, or any combination thereof.

7. The light-emitting device of any one of claims 1 to 6, wherein L₁ to L₄ are each a single bond, and
L₅ and L₆ are each independently:
a single bond; or
a phenylene group, a naphthylene group, a phenanthrenylene group, a carbazolylene group, a dibenzofuranylene group, a benzoquinolinylene group, a benzoisoquinolinylene group, a phenanthridinylene group, a benzimidazolylene group, or a benzoxazolylene group, each unsubstituted or substituted with deuterium, -F, -Cl, - Br, -I, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a naphthyl group, a phenanthrenyl group, a carbazolyl group, a dibenzofuranyl group, a benzoquinolinyl group, a benzoisoquinolinyl group, a phenanthridinyl group, a benzoimidazolyl group, a benzoxazolyl group, or any combination thereof.

8. The light-emitting device of any one of claims 1 to 7, wherein R₁ to R₆ are each independently:
hydrogen, deuterium, -F, a cyano group, or a C₁-C₂₀ alkyl group; or
a phenyl group, a biphenyl group, a terphenyl group, a C₁-C₂₀ alkylphenyl group, a naphthyl group, a fluorenyl group, a phenanthrenyl group, an anthracenyl group, a carbazolyl group, a dibenzofuranyl group, a dibenzothiophenyl group, a benzoquinolinyl group, a benzoisoquinolinyl group, a phenanthridinyl group, a benzoimidazolyl group, or a benzoxazolyl group, each unsubstituted or substituted with deuterium, -F, a cyano group, a C₁-C₂₀ alkyl group, a C₁-C₂₀ alkoxy group, a phenyl group, a biphenyl group, a terphenyl group, a C₁-C₂₀ alkylphenyl group, a naphthyl group, a fluorenyl group, a phenanthrenyl group, an anthracenyl group, a carbazolyl group, a dibenzofuranyl group, a dibenzothiophenyl group, a benzoquinolinyl group, a benzoisoquinolinyl group, a phenanthridinyl group, a benzoimidazolyl group, a benzoxazolyl group, or any combination thereof.

9. The light-emitting device of any one of claims 1 to 8, wherein R₁ to R₄ are each independently hydrogen, deuterium, -F, a cyano group, or C₁-C₂₀ alkyl group, and
R₅ and R₆ are each independently a phenyl group, a biphenyl group, a terphenyl group, a C₁-C₂₀ alkylphenyl group, a naphthyl group, a fluorenyl group, a phenanthrenyl group, an anthracenyl group, a carbazolyl group, a dibenzofuranyl group, a dibenzothiophenyl group, a benzoquinolinyl group, a benzoisoquinolinyl group, a phenanthridinyl group, a benzoimidazolyl group, or a benzoxazolyl group, each unsubstituted or substituted with deuterium, -F, a cyano group, a C₁-C₂₀ alkyl group, a C₁-C₂₀ alkoxy group, a phenyl group, a biphenyl group, a terphenyl group, a C₁-C₂₀ alkylphenyl group, a naphthyl group, a fluorenyl group, a phenanthrenyl group, an anthracenyl group, a carbazolyl group, a dibenzofuranyl group, a dibenzothiophenyl group, a benzoquinolinyl group, a benzoisoquinolinyl group, a phenanthridinyl group, a benzoimidazolyl group, a benzoxazolyl group, or any combination thereof.

10. The light-emitting device of any one of claims 1 to 9, wherein a hole mobility of the heterocyclic compound is in a range of 0.01 cm²/V·s to 0.1 cm²/V·s.

11. The light-emitting device of any one of claims 1 to 10, wherein the heterocyclic compound is one of Compounds 1-1 to 1-15:

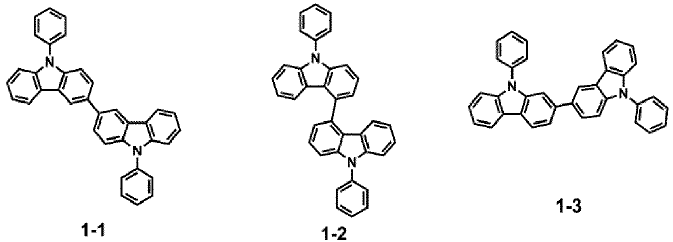

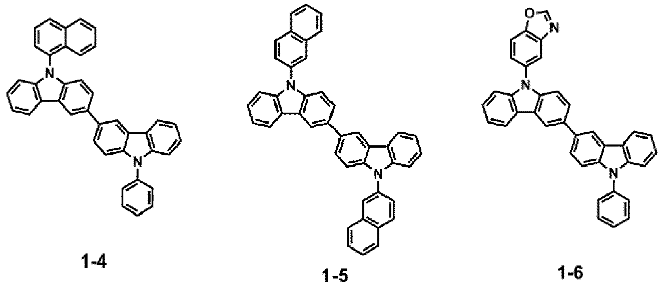

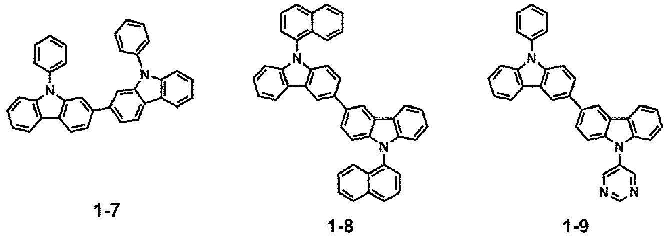

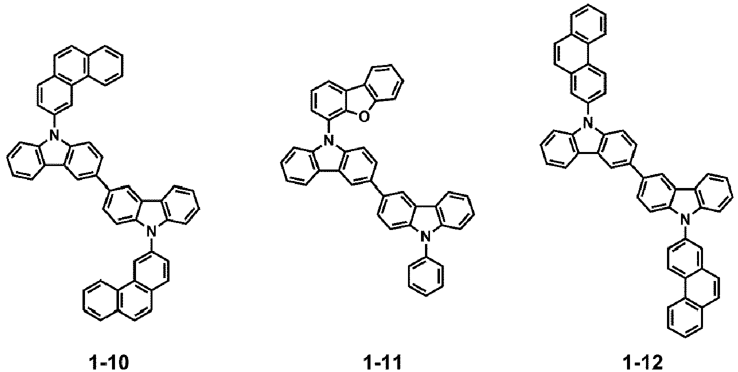

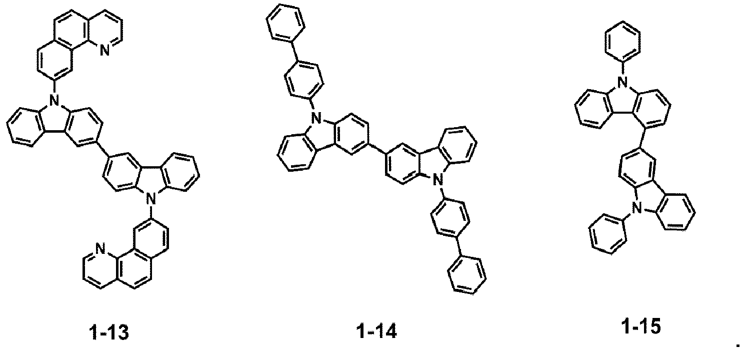

12. The light-emitting device of any one of claims 1 to 11, wherein the interlayer further comprises an electron transport region arranged between the emission layer and the second electrode,
the hole transport region further comprises a hole injection layer, a hole transport layer, an emission auxiliary layer, or any combination thereof, and
the electron transport region comprises a buffer layer, a hole blocking layer, an electron control layer, an electron transport layer, an electron injection layer, or any combination thereof; and/or
wherein the electron blocking layer is in direct contact with the emission layer; and/or
wherein the emission layer is configured to emit blue light.

13. The light-emitting device of any one of claims 1 to 12, further comprising:
m emitting units between the first electrode and a layer of the interlayer, m-1 charge-generating unit(s) between neighboring emitting units among the m emitting units, and a charge-generating unit between an emitting unit adjacent to the layer of the interlayer among the m emitting units and the layer of the interlayer;
n emitting units between the second electrode and a layer of the interlayer, n-1 charge-generating unit(s) between neighboring emitting units among the n emitting units, and a charge-generating unit between an emitting unit adjacent to the layer of the interlayer among the n emitting units and the layer of the interlayer;
or a combination thereof,
wherein m and n are each independently an integer from 1 to 3.

14. The light-emitting device of claim 13, wherein at least one of the m emitting units or the n emitting units is configured to emit blue light; optionally:
wherein the electron blocking layer is between the at least one emitting unit configured to emit blue light and the first electrode, and
the electron blocking layer is in direct contact with the at least one emitting unit configured to emit blue light.

15. An electronic apparatus comprising the light-emitting device of any one of claims 1 to 14; optionally:
further comprising a thin-film transistor,
wherein the thin-film transistor comprises a source electrode and a drain electrode, and
the first electrode of the light-emitting device is electrically connected to at least one of the source electrode or the drain electrode of the thin-film transistor; and/or
further comprising a color filter, a quantum dot color conversion layer, a touch screen layer, a polarizing layer, or any combination thereof.
